# EUROPEAN PATENT APPLICATION

(11) **EP 4 459 674 A1**
(43) Date of publication of application: **06.11.2024**
(21) Application number: 23857016.2
(22) Date of filing: 12.07.2023
(51) Int. Cl.: H01L 23/473

(54) **SEMICONDUCTOR DEVICE**

(30) Priority: 24.08.2022 JP 2022132988
(71) Applicant: Fuji Electric Co., Ltd., Kawasaki-shi, Kanagawa 210-9530 (JP)
(72) Inventor: ADACHI, Shinichiro, Kawasaki-shi, Kanagawa 210-9530 (JP)
(74) Representative: MERH-IP Matias Erny Reichl Hoffmann Patentanwälte PartG mbB
(86) International application number: PCT/JP2023/025669
(87) International publication number: WO 2024/042899

(57) **Abstract**

To suppress a reduction in cooling performance.

A cooling chassis (40) has outer lateral faces (40a, 40c) located on the long sides and outer lateral faces (40b, 40d) located on the short sides in plan view. An inlet (40h) communicating with a flow passage area (41) is formed, on the outer lateral face (40b), at a position closer to the outer lateral face (40c). A medium is introduced and flows through the inlet (40h) in the longitudinal direction toward the flow passage area (41). An inflow area (42) is formed, on a flow passage bottom face (41e), at a position closer to the inlet (40h). The inflow area (42) is recessed in a concave shape from the flow passage bottom face (41e), communicates with the inlet (40h), and includes a diffusion face (42d) opposing the inlet (40h).

## Description

### Technical Field

The embodiments discussed herein relate to a semiconductor device.

### Background Art

Semiconductor devices include a semiconductor module and a cooling device. The cooling device includes an inlet through which a refrigerant flows into the inside of the cooling device and an outlet through which the refrigerant flows out from the inside. In the cooling device, distribution pipes are individually connected to each of the inlet and the outlet. In addition, a pump is connected to each of the distribution pipes. The refrigerant flows into the cooling device from the inlet by the pump, then circulates through the cooling device, and flows out from the outlet. The discharged refrigerant is caused to flow into the cooling device again through the inlet by the pump. The semiconductor module is disposed on the cooling surface of the cooling device with the aforementioned configuration. The cooling device cools the semiconductor module that generates heat to thereby ensure the reliability of the semiconductor module (see, for example, PTL1 to PTL5 below).

In addition, the semiconductor devices include a capacitor together with the semiconductor module. The capacitor is installed near the semiconductor module. On the other hand, the semiconductor devices have a problem in that the installation position of the capacitor is limited by where the distribution pipes of the cooling device are placed. Hence, the distribution pipes of the cooling device need to be connected in locations that do not interfere with the installation of the capacitor.

### Citation List

### Patent Literature

[PTL1] Japanese Laid-open Patent Publication No. 2013-058518
[PTL2] Japanese Laid-open Patent Publication No. 2016-096272
[PTL3] International Publication Pamphlet No. WO 2011/132736
[PTL4] International Publication Pamphlet No. WO 2016/047335
[PTL5] International Publication Pamphlet No. WO 2014/069174

### Summary of Invention

### Technical Problem

However, depending on the positions of the inlet and the outlet of the cooling device, the refrigerant introduced from the inlet may be unable to circulate throughout the inside of the cooling device, which may cause variations in cooling performance on the cooling surface of the cooling device. The reduced cooling performance may lead to improper cooling of the semiconductor module, which in turn may result in decreased output performance and reliability of the semiconductor devices.

In view of the above-described problems, the embodiments aim at providing a semiconductor device with suppressed decrease in cooling performance.

### Solution to Problem

According to an aspect, there is provided a semiconductor device including a semiconductor chip; and a cooling device configured to have the semiconductor chip mounted thereon, wherein the cooling device includes a top plate including a first top face on which the semiconductor chip is placed and a first lower face opposite the first top face, and a cooling chassis including a second top face having a rectangular shape in plan view and surrounded on all four sides sequentially by a first outer lateral face, a second outer lateral face, a third outer lateral face, and a fourth outer lateral face, on which second top face a flow passage area is provided, which has a concave shape and includes a flow passage bottom face recessed from the second top face, the flow passage area being closed with the top plate by disposing the first lower face of the top plate on the second top face, and the cooling chassis is configured such that the first outer lateral face and the third outer lateral face are located on long sides thereof and the second outer lateral face and the fourth outer lateral face are located on short sides; an inlet is provided, on the second outer lateral face, at a position closer to the third outer lateral face, and communicates with the flow passage area, a cooling medium being introduced and flowing through the inlet in a longitudinal direction toward the flow passage area; an inflow area is provided, on the flow passage bottom face, at a position closer to the inlet, the inflow area being recessed in a concave shape from the flow passage bottom face and communicating with the inlet; and the inflow area includes a diffusion face opposing the inlet.

### Advantageous Effects of Invention

According to an aspect, it is possible to suppress reduced cooling performance without restricting the installation area of the capacitor and prevent decreased reliability of the semiconductor device.

The foregoing and other objects, features, and advantages of the invention will become more readily apparent from the following detailed description of preferred embodiments of the invention which proceeds with reference to the accompanying drawings.

### Brief Description of Drawings

[FIG. 1] FIG. 1 is a plan view of a semiconductor device according to a first embodiment.
[FIG. 2] FIG. 2 is a lateral view of the semiconductor device of the first embodiment.
[FIG. 3] FIG. 3 is a plan view of a semiconductor unit included in the semiconductor device of the first embodiment.
[FIG. 4] FIG. 4 is a (first) cross-sectional view of the semiconductor unit included in the semiconductor device of the first embodiment.
[FIG. 5] FIG. 5 is a (second) cross-sectional view of the semiconductor unit included in the semiconductor device of the first embodiment.
[FIG. 6] FIG. 6 is a perspective view of a cooling device included in the semiconductor device of the first embodiment.
[FIG. 7] FIG. 7 is a back view of a top plate of the cooling device included in the semiconductor device of the first embodiment.
[FIG. 8] FIG. 8 is a cross-sectional view of the cooling device included in the semiconductor device of the first embodiment.
[FIG. 9] FIG. 9 is a (first) cross-sectional view of a cooling chassis of the cooling device included in the semiconductor device of the first embodiment.
[FIG. 10] FIG. 10 is a (second) cross-sectional view of the cooling chassis of the cooling device included in the semiconductor device of the first embodiment.
[FIG. 11] FIG. 11 is a cross-sectional view of another cooling chassis of the cooling device included in the semiconductor device of the first embodiment.
[FIG. 12] FIG. 12 illustrates flow passages of a refrigerant of a cooling device included in a semiconductor device of a reference example.
[FIG. 13] FIG. 13 illustrates a flow of the refrigerant of the cooling device included in the semiconductor device of the first embodiment.
[FIG. 14] FIG. 14 is plan views each illustrating the cooling chassis of the cooling device included in the semiconductor device of the first embodiment (Modification 1-1) .
[FIG. 15] FIG. 15 is a plan view of the cooling chassis of the cooling device included in the semiconductor device of the first embodiment (Modification 1-2).
[FIG. 16] FIG. 16 is a plan view of a cooling chassis of a cooling device included in a semiconductor device of a second embodiment.
[FIG. 17] FIG. 17 is a (first) cross-sectional view of the cooling chassis of the cooling device included in the semiconductor device of the second embodiment.
[FIG. 18] FIG. 18 is a (second) cross-sectional view of the cooling chassis of the cooling device included in the semiconductor device of the second embodiment.
[FIG. 19] FIG. 19 illustrates a flow of the refrigerant of the cooling device included in the semiconductor device of the second embodiment.
[FIG. 20] FIG. 20 is a cross-sectional view of the cooling chassis of the cooling device included in the semiconductor device of the second embodiment (Modification 2-1).
[FIG. 21] FIG. 21 is a plan view of a cooling chassis of a cooling device included in a semiconductor device of a third embodiment.
[FIG. 22] FIG. 22 is a (first) cross-sectional view of the cooling chassis of the cooling device included in the semiconductor device of the third embodiment.
[FIG. 23] FIG. 23 is a (second) cross-sectional view of the cooling chassis of the cooling device included in the semiconductor device of the third embodiment.

### Description of Embodiments

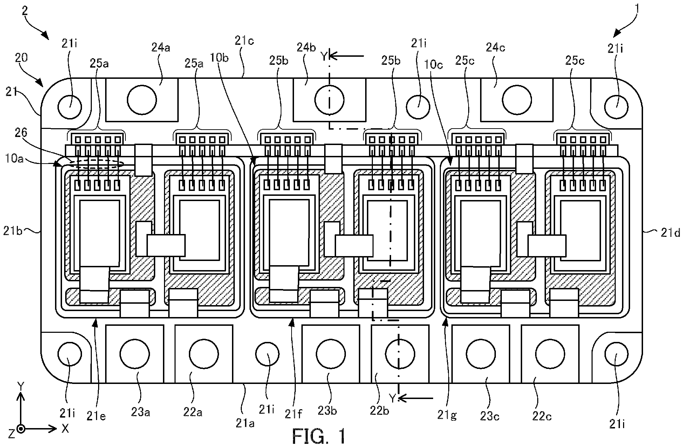

Several embodiments will be described below with reference to the accompanying drawings. Note that in the following the terms "front surface" and "top face" refer to the X-Y plane facing upward (the +Z direction) in a semiconductor device 1 of FIG. 1. Similarly, the term "upper" refers to the upward direction (the +Z direction) of the semiconductor device 1 of FIG. 1. On the other hand, the terms "rear surface" and "lower face" refer to the X-Y plane facing downward (the -Z direction) in the semiconductor device 1 of FIG. 1. Similarly, the term "lower" refers to the downward direction (the -Z direction) of the semiconductor device 1 of FIG. 1. These terms have the same orientational relationships in other drawings if needed. The terms "front surface", "top face", and "upper"; the terms "rear surface", "lower face", and "lower"; and the term "lateral face" are simply expedient expressions used to specify relative positional relationships, and are not intended to limit the technical ideas of the embodiments described herein. For example, the terms "upper" and "lower" do not necessarily imply the vertical direction to the ground surface. That is, the "upper" and "lower" directions are not defined in relation to the direction of the gravitational force. In addition, the term "major component" in the following refers to a constituent having a concentration equal to 80 vol% or higher. The phrase "substantially the same" refers to where two or more things being compared have a difference of no more than ±10%. In addition, the terms "perpendicular" and "parallel" may also include substantially perpendicular and substantially parallel, as appropriate, which may include a margin of error of ±10° or less.

### [First Embodiment]

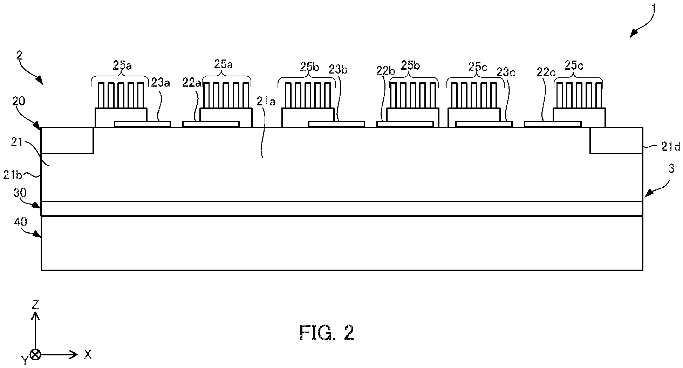

Next described is the semiconductor device 1 of a first embodiment with reference to FIGS. 1 and 2. FIG. 1 is a plan view of the semiconductor device according to the first embodiment. FIG. 2 is a lateral view of the semiconductor device of the first embodiment. Note that the lateral view of FIG. 2 is obtained when the X-Z plane is seen in the +Y direction in FIG. 1.

The semiconductor device 1 includes a semiconductor module 2 and a cooling device 3. The semiconductor module 2 includes semiconductor units 10a, 10b, and 10c and a chassis 20 for housing the semiconductor units 10a, 10b, and 10c. The semiconductor units 10a, 10b, and 10c housed in the chassis 20 are sealed with sealing members (not illustrated). Note that the semiconductor units 10a, 10b, and 10c all have the same configuration. Note that the term "semiconductor units 10" is used in the following description when no distinction is made among the semiconductor units 10a, 10b, and 10c. Details of the semiconductor units 10 will be described later.

The chassis 20 includes an outer frame 21; first connection terminals 22a, 22b, and 22c; second connection terminals 23a, 23b, and 23c; a U-phase output terminal 24a; a V-phase output terminal 24b; a W-phase output terminal 24c; and control terminals 25a, 25b, and 25c.

The outer frame 21 has a substantially rectangular shape in plan view, and is surrounded on all four sides sequentially by outer walls 21a, 21b, 21c, and 21d. In plan view, the outer walls 21a and 21c correspond to the long sides of the outer frame 21 while the outer walls 21b and 21d correspond to short sides of the outer frame 21. The corners at which the outer walls 21a, 21b, 21c, and 21d are connected to each other do not necessarily form right angles. They may be R-chamfered corners as illustrated in FIG. 1. Through holes 21i penetrating the outer frame 21 are individually formed at each corner of the front surface of the outer frame 21. Note that the through holes 21i provided in such corners of the outer frame 21 may be formed below the front surface of the outer frame 21.

The outer frame 21 includes unit housing parts 21e, 21f, and 21g disposed on the front surface along the outer walls 21a and 21c. The unit housing parts 21e, 21f, and 21g have a rectangular shape in plan view. The semiconductor units 10a, 10b, and 10c are housed in the unit housing parts 21e, 21f, and 21g, respectively.

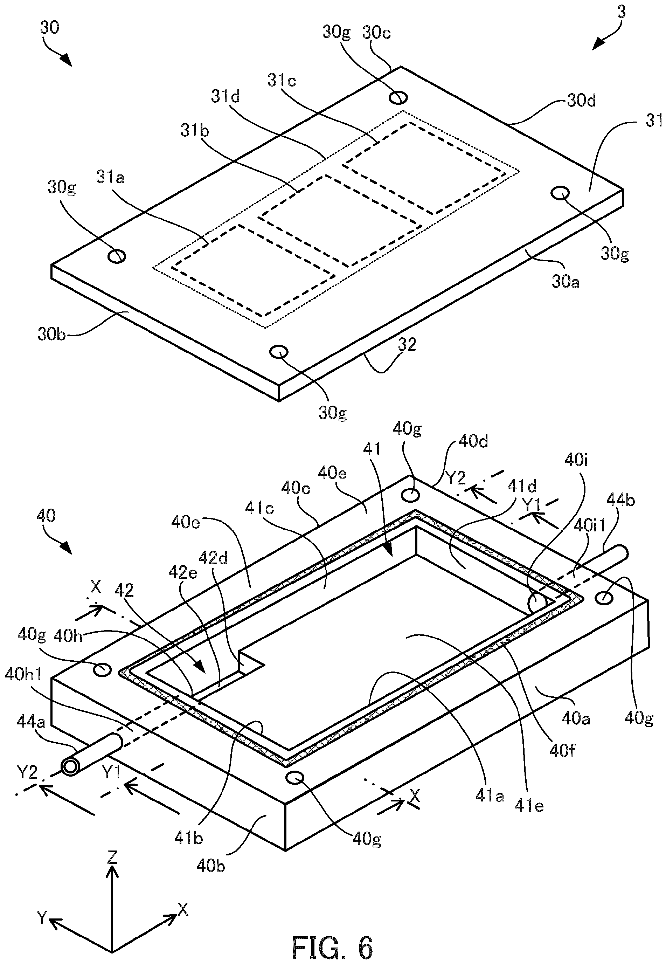

The outer frame 21 is placed on a top face 31 (see FIG. 6), which is a cooling surface of a top plate 30 of the cooling device 3. On the top face 31 of the cooling device 3, the individual semiconductor units 10a, 10b, and 10c are disposed in advance along the X direction. When the outer frame 21 is placed on the top face 31, the unit housing parts 21e, 21f, and 21g of the outer frame 21 surround (i.e., house) the semiconductor units 10a, 10b, and 10c, respectively, aligned on the cooling device 3.

On the front surface of the outer frame 21 in plan view, the first and second connection terminals 22a and 23a are located across the unit housing part 21e from the U-phase output terminal 24a in the ±Y direction. In the same manner, the first and second connection terminals 22b and 23b are located across the unit housing part 21f from the V-phase output terminal 24b, and the first and second connection terminals 22c and 23c are located across the unit housing part 21g from the W-phase output terminal 24c.

The outer frame 21 has, on its front surface, the first connection terminals 22a, 22b, and 22c and the second connection terminals 23a, 23b, and 23c provided on the outer wall 21a side in plan view. A first end, which is an outer end, of each of the first connection terminals 22a, 22b, and 22c and the second connection terminals 23a, 23b, and 23c is exposed to the front surface on the outer wall 21a side. Their second ends, which are inner ends, individually emerge inside the unit housing parts 21e, 21f, and 21g and are electrically connected to the semiconductor units 10a, 10b, and 10c.

The outer frame 21 includes, on its front surface, the U-phase output terminal 24a, the V-phase output terminal 24b, and the W-phase output terminal 24c on the outer wall 21c side. First ends, which are outer ends, of the U-phase output terminal 24a, the V-phase output terminal 24b, and the W-phase output terminal 24c are exposed to the front surface on the outer wall 21c side. On the other hand, their second ends, which are inner ends, individually emerge inside the unit housing parts 21e, 21f, and 21g and are electrically connected to the semiconductor units 10a, 10b, and 10c.

The outer frame 21 also has nuts housed in the lower part (in the -Z direction) of individual openings for the outer ends of the first connection terminals 22a, 22b, and 22c and the second connection terminals 23a, 23b, and 23c in such a manner that the nuts face the openings. Similarly, the outer frame 21 has nuts housed in the lower part of individual openings for the U-phase output terminal 24a, the V-phase output terminal 24b, and the W-phase output terminal 24c in such a manner that the nuts face the openings.

Further, the outer frame 21 is provided with the control terminals 25a, 25b, and 25c along the +Y direction sides (the outer wall 21c side) of the unit housing parts 21e, 21f, and 21g, respectively, in plan view. Each set of the control terminals 25a, 25b, and 25c is divided into two groups. The control terminals 25a, 25b, and 25c have a J-shape (or a U-shape). First ends, which are outer ends, of the control terminals 25a, 25b, and 25c extend vertically upward (in the +Z direction) from the front surface of the outer frame 21 on the outer wall 21c side. Their second ends, which are inner ends, are exposed vertically upward (in the +Z direction) from the front surface on the individual unit housing part 21e, 21f, and 21g sides. Note that the illustrated control terminals 25a, 25b, and 25c are merely an example, and appropriate changes may be made to their shape and number on an as-needed basis.

The outer frame 21 with the above-described configuration includes the first connection terminals 22a, 22b, and 22c, the second connection terminals 23a, 23b, and 23c, the U-phase output terminal 24a, the V-phase output terminal 24b, the W-phase output terminal 24c, and the control terminals 25a, 25b, and 25c. The outer frame 21 and these terminals are integrally formed by injection molding using a thermoplastic resin. In this manner, the chassis 20 is configured. As the thermoplastic resin, any of the following may be used, for example: a poly phenylene sulfide resin; a polybutylene terephthalate resin; a polybutylene succinate resin; a polyamide resin; and an acrylonitrile butadiene styrene resin.

The first connection terminals 22a, 22b, and 22c, the second connection terminals 23a, 23b, and 23c, the U-phase output terminal 24a, the V-phase output terminal 24b, the W-phase output terminal 24c, and the control terminals 25a, 25b, and 25c are made of a metal with excellent electrical conductivity. Such a metal is, for example, copper, aluminum, or an alloy containing at least one of these as a major component. Plating may be applied to coat the surfaces of the first connection terminals 22a, 22b, and 22c, the second connection terminals 23a, 23b, and 23c, the U-phase output terminal 24a, the V-phase output terminal 24b, the W-phase output terminal 24c, and the control terminals 25a, 25b, and 25c. In this case, a material used for plating is, for example, nickel, a nickel-phosphorus alloy, or a nickel-boron alloy.

The sealing member for sealing the unit housing parts 21e, 21f, and 21g may be a silicone gel or thermosetting resin. The thermosetting resin is, for example, epoxy resin, phenolic resin, maleimide resin, or polyester resin; however, epoxy resin is preferred. A filler may be added to the sealing member. The filler may be ceramic with insulation properties and high thermal conductivity.

The cooling device 3 includes the top plate 30 on which the above-described semiconductor module 2 is placed; and a cooling chassis 40 provided with an inlet and an outlet, on which the top plate 30 is disposed. A pump is connected to the cooling device 3 the cooling device 3 with the foregoing configuration. In the cooling device 3, a refrigerant, which is a cooling medium, is circulated by the pump. That is, the pump causes the refrigerant to be introduced into the cooling device 3 and then move around inside the cooling device 3. At this time, the refrigerant receives heat from the semiconductor module 2 to thereby cool the semiconductor module 2. The refrigerant having received heat is then discharged to the outside of the cooling device 3. In this manner, the refrigerant is circulated inside the cooling device 3 by the pump. Details of the cooling device 3 will be described later.

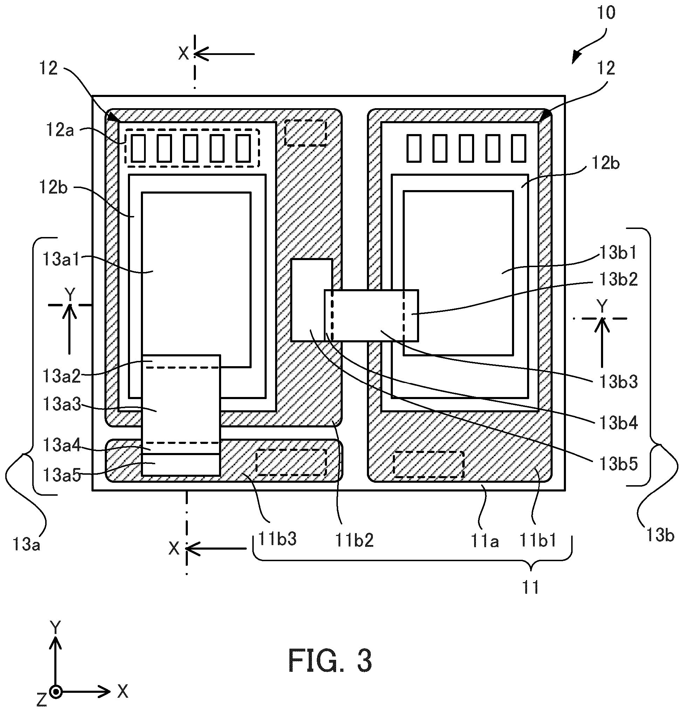

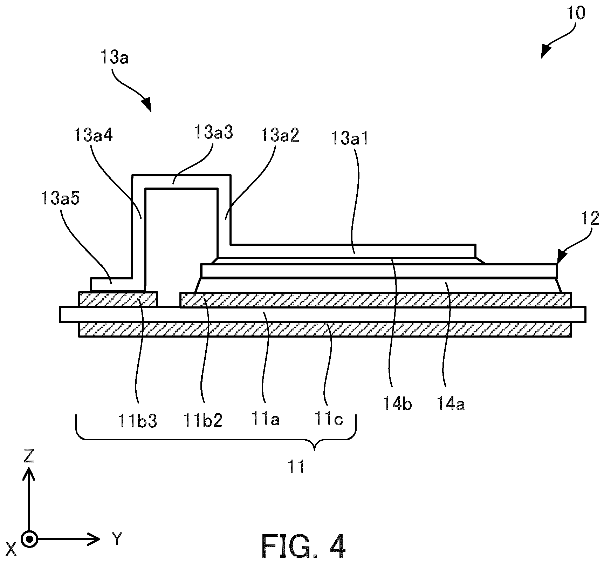

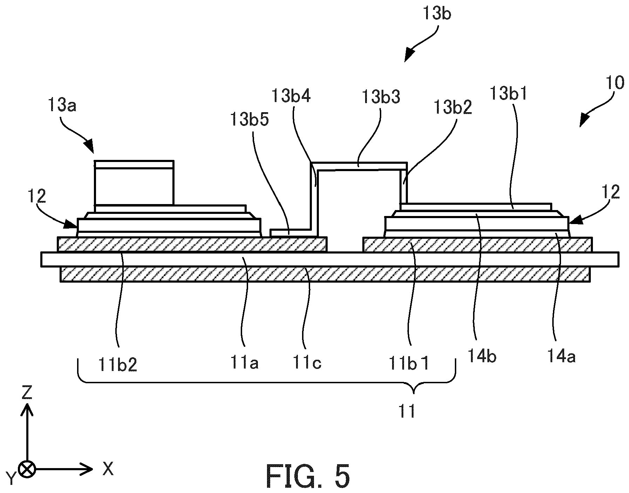

Next described are the semiconductor units 10a, 10b, and 10c with reference to FIGS. 3 to 5. FIG. 3 is a plan view of a semiconductor unit included in the semiconductor device of the first embodiment. FIGS. 4 and 5 are cross-sectional views of the semiconductor unit included in the semiconductor device of the first embodiment. Note that the cross-sectional view of FIG. 4 is taken along dashed-dotted line X-X of FIG. 3, and the cross-sectional view of FIG. 5 is taken along dashed-dotted line Y-Y of FIG. 3.

Each of the semiconductor units 10 includes an insulated circuit board 11, two semiconductor chips 12, and lead frames 13a and 13b. The semiconductor chips 12 are bonded to the insulated circuit board 11 with bonding members 14a. The lead frames 13a and 13b are bonded to main electrodes on the front surfaces of the semiconductor chips 12 with bonding members 14b. Note that, instead of the bonding members 14b, ultrasonic bonding may be used to bond the lead frames 13a and 13b to the insulated circuit board 11.

The insulated circuit board 11 includes an insulating plate 11a, wiring boards 11b1, 11b2, and 11b3, and a metal plate 11c. The insulating plate 11a and the metal plate 11c have a rectangular shape in plan view. In addition, the insulating plate 11a and the metal plate 11c may have R- or C-chamfered corners. The metal plate 11c is smaller in size than the insulating plate 11a in plan view, and is thus formed within the insulating plate 11a.

The insulating plate 11a is made of a material with insulation properties and excellent thermal conductivity. The insulating plate 11a may be made of ceramic. The ceramic here is, for example, aluminum oxide, aluminum nitride, or silicon nitride.

The wiring boards 11b1, 11b2, and 11b3 are formed on the front surface of the insulating plate 11a. The wiring boards 11b1, 11b2, and 11b3 are made of a metal with excellent electrical conductivity. The metal is, for example, copper, aluminum, or an alloy whose major component is at least one of these. Plating may be applied to coat the entire surfaces of the wiring boards 11b1, 11b2, and 11b3 in order to provide improved corrosion resistance. In this case, a material used for plating is, for example, nickel, a nickel-phosphorus alloy, or a nickel-boron alloy.

The wiring board 11b1 occupies half the area of the front surface of the insulating plate 11a on the +X direction side, and spreads across the entire region from the -Y direction side to the +Y direction side. To the area surrounded by the broken line indicated on the wiring board 11b1, the inner end of the first connection terminal 22a, 22b, or 22c is joined. Note that the area surrounded by the broken line on the wiring board 11b1 and the inner end of the first connection terminal 22a, 22b, or 22c may be joined via a conductive block body.

The wiring board 11b2 occupies half the area of the front surface of the insulating plate 11a on the -X direction side. In addition, the wiring board 11b2 extends from the +Y direction side of the front surface of the insulating plate 11a to just short of the -Y direction side. To the area surrounded by the broken line indicated on the wiring board 11b2, the inner end of the U-phase output terminal 24a, the V-phase output terminal 24b, or the W-phase output terminal 24c is joined. The area surrounded by the broken line on the wiring board 11b2 and the U-phase output terminal 24a, the V-phase output terminal 24b, or the W-phase output terminal 24c may be joined via a conductive block body.

The wiring board 11b3 occupies, on the front surface of the insulating plate 11a, an area surrounded by the wiring boards 11b1 and 11b2. To the area surrounded by the broken line indicated on the wiring board 11b3, the inner end of the first connection terminal 22a, 22b, or 22c is joined. The area surrounded by the broken line on the wiring board 11b3 and the end of the first connection terminal 22a, 22b, or 22c may be joined via a conductive block body.

The above-described wiring boards 11b1, 11b2, and 11b3 are formed on the front surface of the insulating plate 11a by the following means. For example, a metal layer is formed on the front surface of the insulating plate 11a and then subjected to etching or the like, to thereby obtain the wiring boards 11b1, 11b2, and 11b3 with predetermined shapes. Alternatively, the wiring boards 11b1, 11b2, and 11b3 preliminarily cut out of a metal layer are pressure bonded to the front surface of the insulating plate 11a. Note that the wiring boards 11b1, 11b2, and 11b3 are merely an example, and appropriate changes may be made to the number of the wiring boards 11b1, 11b2, and 11b3, their shapes, sizes and locations on an as-needed basis.

The metal plate 11c is formed on the rear surface of the insulating plate 11a. The metal plate 11c has a rectangular shape. The area of the metal plate 11c in plan view is smaller than that of the insulating plate 11a, but larger than the area where the wiring boards 11b1, 11b2, and 11b3 are formed. The metal plate 11c may have R- or C-chamfered corners. The metal plate 11c is smaller in size than the insulating plate 11a, and is formed on the entire surface of the insulating plate 11a except for the edges. The metal plate 11c is made of a metal with excellent thermal conductivity as a major component. The metal is, for example, copper, aluminum, or an alloy including at least one of these.

Examples of the insulated circuit board 11 having the above-described configuration include a direct copper bonding (DCB) board and an active metal brazed (AMB) board. The insulated circuit board 11 may be attached to the front surface of the cooling device 3 via a bonding member (not illustrated). This allows heat generated in the semiconductor chip 12 to be conducted to the cooling device 3 via the wiring boards 11b1 and 11b2, the insulating plate 11a, and the metal plate 11c and then radiated outwards.

The bonding members 14a and 14b are solder, for example. The solder used is lead-free solder. The lead-free solder contains, as a major component, an alloy containing at least two selected from tin, silver, copper, zinc, antimony, indium, and bismuth, for example. Further, the solder may include an additive, such as nickel, germanium, cobalt, or silicon. The inclusion of the additive increases wettability, brightness, and bond strength of the solder, which results in improved reliability.

The bonding member (not illustrated) for bonding the individual semiconductor units 10 and the cooling device 3 may be a brazing material or thermal interface material. The brazing material contains, as a major component, at least one selected from an aluminum alloy, a titanium alloy, a magnesium alloy, a zirconium alloy, and a silicon alloy, for example. The thermal interface material is an adhesive material, such as an elastomer sheet, room temperature vulcanization (RTV) rubber, gel, and a phase change material. Attachment of the semiconductor units 10 to the cooling device 3 via the foregoing brazing material or thermal interface material improves heat dissipation of the semiconductor units 10.

Each of the semiconductor chip 12 includes a power device element made of silicone. The power device element is, for example, a reverse-conducting insulated gate bipolar transistor (RC-IGBT). The RC-IGBT has integrated functions of both an IGBT, which is a switching element, and a free wheeling diode (FWD), which is a diode element. On the front surface of the semiconductor chip 12, control electrodes 12a (a gate electrode) and an output electrode (an emitter electrode), which is a main electrode 12b, are provided. On the rear surface of the semiconductor chip 12, an input electrode (a collector electrode), which is a main electrode, is provided. Note that the control electrodes 12a are laid out along one side of the front surface of the semiconductor chip 12 (or at the center of the one side). The output electrode is disposed at the center of the front surface of the semiconductor chip 12.

Note that, as the semiconductor chip 12, a pair of a switching element and a diode element may be used instead of an RC-IGBT. The switching element is, for example, an IGBT or power metal oxide semiconductor field effect transistor (power MOSFET) . Such a semiconductor chip 12 has, for example, an input electrode (a drain or collector electrode) as a main electrode on the rear surface, and the control electrodes 12a (a gate electrode) and the output electrode (a source or emitter electrode) as the main electrode 12b on the front surface. On the other hand, the diode element is, for example, an FWD, such as a Schottky barrier diode (SBD) and a P-intrinsic-N (PiN) diode. Such a semiconductor chip 12 has an output electrode (a cathode electrode) as a main electrode on the rear surface, and an input electrode (an anode electrode) as a main electrode on the front surface.

The semiconductor chip 12 may include a switching element which is a power MOSFET whose major component is silicon carbide. Such a semiconductor chip 12 has the control electrodes 12a (a gate electrode) and the output electrode (a source electrode) as the main electrode 12b on the front surface, and an input electrode (a drain electrode) as a main electrode on the rear surface.

The lead frames 13a and 13b electrically connect the semiconductor chips 12 and the wiring boards 11b1, 11b2, and 11b3, to make wiring connections. Each of the semiconductor units 10 may be a device that serves as a single-phase inverter circuit. The lead frame 13a directly connects the main electrode 12b of the semiconductor chip 12 (on the wiring board 11b2) and the wiring board 11b3. The lead frame 13b connects the main electrode 12b of the semiconductor chip 12 (on the wiring board 11b1) and the wiring board 11b2.

The lead frames 13a and 13b integrally include the following respectively: main electrode bonding parts 13a1 and 13b1; first vertical linking parts 13a2 and 13b2; horizontal linking parts 13a3 and 13b3; second vertical linking parts 13a4 and 13b4; and wiring bonding parts 13a5 and 13b5. Note that the lead frames 13a and 13b have the same thickness throughout and are in the form of flat plates. The aforementioned individual parts of the lead frames 13a and 13b may be configured by bending. The lead frames 13a and 13b are made of a metal with excellent electrical conductivity. The metal is, for example, copper, aluminum, or an alloy whose major component is at least one of these. In order to provide improved corrosion resistance, plating may be applied to coat the entire surfaces of the lead frames 13a and 13b. In this case, a material used for plating is, for example, nickel, a nickel-phosphorus alloy, or a nickel-boron alloy.

The main electrode bonding parts 13a1 and 13b1 have a flat plate shape. The main electrode bonding parts 13a1 and 13b1 are joined to the main electrodes 12b of the semiconductor chips 12 (each provided on the wiring boards 11b2 and llbl) with the bonding members 14a. Note that the main electrode bonding parts 13a1 and 13b1 have a rectangular shape in plan view, similar to the main electrodes 12b.

As for the first vertical linking parts 13a2 and 13b2, their lower ends are integrally connected to edges of the main electrode bonding parts 13a1 and 13b1, and their upper ends extend vertically upward (in the +Z direction) relative to the main electrode bonding parts 13a1 and 13b1. The first vertical linking part 13a2 is bonded to an edge portion of the main electrode bonding part 13a1 bonded to the semiconductor chip 12, which edge portion is located closer to the wiring board 11b3 (in the -Y direction). The first vertical linking part 13b2 is bonded to an edge portion of the main electrode bonding part 13b1 bonded to the semiconductor chip 12, which edge portion is located closer to the wiring board 11b2 (in the -X direction) in the -Y direction.

The horizontal linking parts 13a3 and 13b3 are integrally connected to the upper ends of the first vertical linking parts 13a2 and 13b2, and extend out over the wiring boards 11b3 and 11b2. At this time, the horizontal linking parts 13a3 and 13b3 straddle the gap between the wiring boards 11b2 and 11b3 and the gap between the wiring boards 11b1 and 11b2, respectively. The horizontal linking parts 13a3 and 13b3 are parallel to the insulated circuit board 11. In addition, the horizontal linking parts 13a3 and 13b3 may be the same in height.

As for the second vertical linking parts 13a4 and 13b4, their upper ends are integrally connected to the edges of the horizontal linking parts 13a3 and 13b3, and their lower ends extend vertically downward (in the -Z direction) and are integrally connected to the wiring bonding parts 13a5 and 13b5.

The wiring bonding parts 13a5 and 13b5 are joined to the wiring boards 11b3 and 11b2 and are integrally connected to the lower ends of the second vertical linking parts 13a4 and 13b4, respectively. Bonding of the wiring bonding parts 13a5 and 13b5 to the wiring boards 11b3 and 11b2 may be achieved using the aforementioned bonding members or by ultrasonic bonding.

The first vertical linking part 13a2, the horizontal linking part 13a3, the second vertical linking part 13a4, and the wiring bonding part 13a5 of the lead frame 13a have the same width. Note that the width here means the length in the direction (the ±X direction) perpendicular to the wiring direction (the ±Y direction) of the lead frame 13a. The first vertical linking part 13b2, the horizontal linking part 13b3, and the second vertical linking part 13b4 of the lead frame 13b have the same width. Note that the width here means the length in the direction (the ±Y direction) perpendicular to the wiring direction (the ±X direction) of the lead frame 13b.

The control electrodes 12a of the semiconductor chips 12 of the semiconductor units 10a, 10b, and 10c housed in the unit housing parts 21e, 21f, and 21f of the chassis 20 are mechanically and electrically connected to the inner ends of the control terminals 25a, 25b, and 25c by wires 26 (see FIG. 1). The wires 26 are made of a material with excellent conductivity as a major component. The material is, for example, gold, copper, aluminum, or an alloy including at least one of these. The wires 26 may preferably be an aluminum alloy containing trace amounts of silicon.

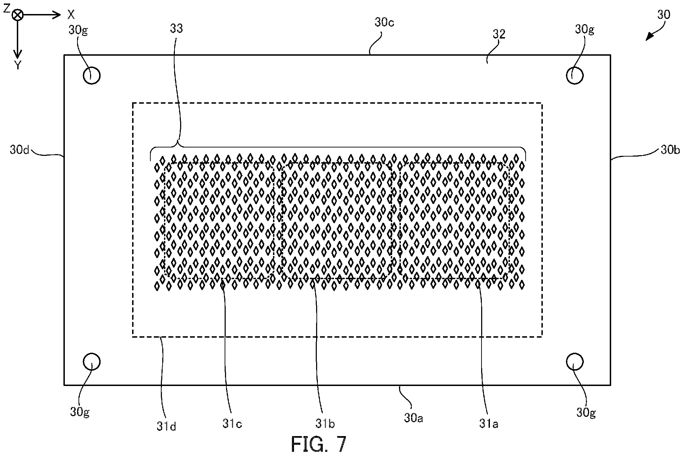

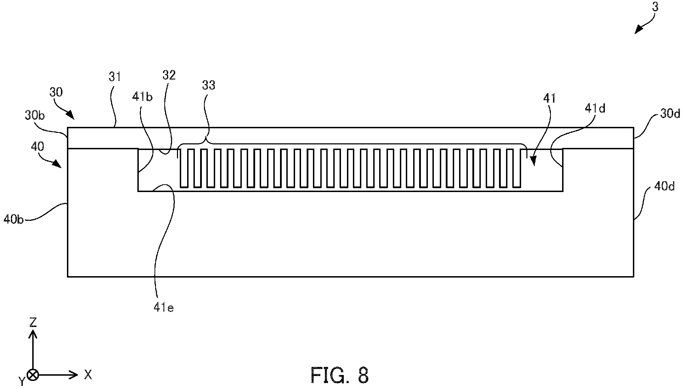

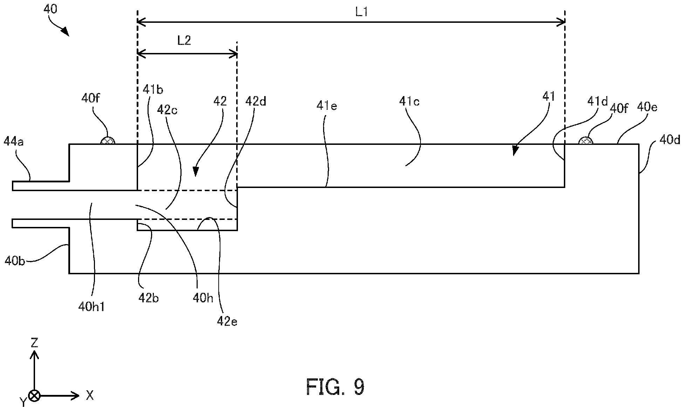

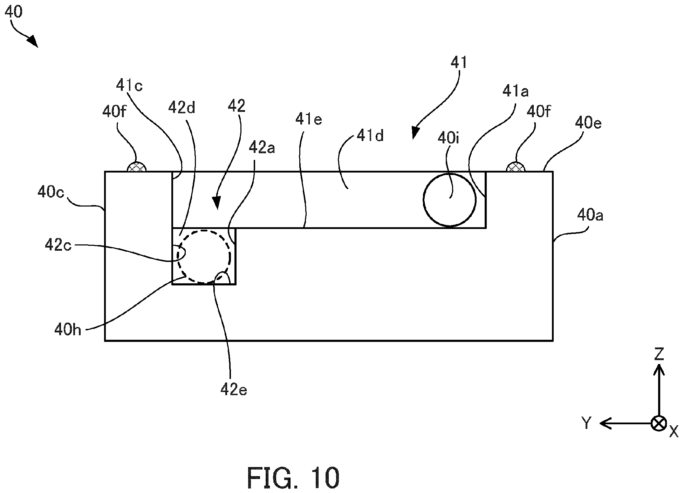

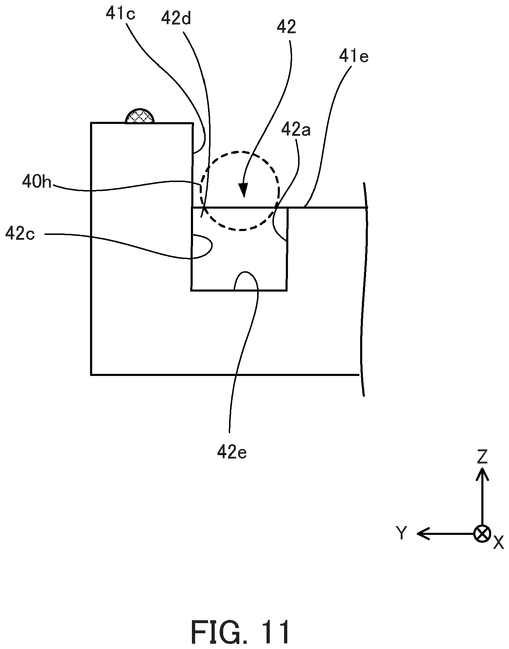

The cooling device 3 is explained next with reference to FIGS. 6 to 11. FIG. 6 is a perspective view of a cooling device included in the semiconductor device of the first embodiment. FIG. 7 is a back view of a top plate of the cooling device included in the semiconductor device of the first embodiment. FIG. 8 is a cross-sectional view of the cooling device included in the semiconductor device of the first embodiment. FIGS. 9 and 10 are cross-sectional views of a cooling chassis of the cooling device included in the semiconductor device of the first embodiment. FIG. 11 is a cross-sectional view of another cooling chassis of the cooling device included in the semiconductor device of the first embodiment.

Note that, in FIG. 6, the cooling device 3 is depicted with the top plate 30 and the cooling chassis 40 separated from each other. FIG. 8 is a cross-sectional view of the cooling chassis 40 with the top plate 30 installed thereon, taken along dashed-dotted line Y1-Y1 of FIG. 6. FIG. 9 is a cross-sectional view of the cooling chassis 40, taken along dashed-dotted line Y2-Y2 of FIG. 6. FIG. 10 is a cross-sectional view of the cooling chassis 40, taken along dashed-dotted line X-X of FIG. 6. In FIG. 10, the position of an inlet 40h in relation to a diffusion face 42d is indicated by the broken line. The cross-sectional view of FIG. 11 corresponds to that of the cooling chassis 40, taken along dashed-dotted line X-X of FIG. 6. Note however that FIG. 11 depicts a case where the inlet 40h is formed at a different position from that represented in FIG. 10. FIG. 11 also depicts the periphery of the diffusion face 42d when viewed in the X direction.

A refrigerant is introduced into the cooling device 3, moves around inside the cooling device 3, and is then discharged to the outside. In this manner, the cooling device 3 cools the semiconductor module 2. Note that the refrigerant is a cooling medium, such as water, an antifreeze solution (ethylene glycol aqueous solution), and a long-life coolant (LLC). The cooling device 3 includes the top plate 30 and the cooling chassis 40. The cooling device 3 is made of a metal with excellent thermal conductivity as a major component. The metal is, for example, copper, aluminum, or an alloy including at least one of these. In order to provide improved corrosion resistance, plating may be applied to the cooling device 3. In this case, a material used for plating is, for example, nickel, a nickel-phosphorus alloy, or a nickel-boron alloy.

The top plate 30 has a rectangular flat plate shape in plan view. The top plate 30 includes the rectangular top face 31 (cooling surface) and a lower face 32 (fin installation surface) opposite and substantially parallel to the top face 31. The top face 31 and the lower face 32 are flat and smooth. The top plate 30 also includes lateral faces 30a to 30d sequentially surrounding the top face 31 and the lower face 32 on all four sides. In plan view, the lateral faces 30a and 30c correspond to the long sides of the top plate 30, and the lateral faces 30b and 30d correspond to the short sides of the top plate 30. Each connection part (corners) of the lateral faces 30a to 30d may be R- or C-chamfered. In addition, the top plate 30 is formed with insertion holes 30g penetrating the top face 31 and the lower face 32. The insertion holes 30g are individually formed, in plan view, outside the corners of a cooling area 31d, which will be described later, on the top face 31 of the top plate 30 and near the corners of the top face 31 and the lower face 32.

On the top face 31, unit areas 31a to 31c are set along the X direction, in which the semiconductor units 10a to 10c, respectively, are disposed. The unit areas 31a to 31c each have a rectangular shape corresponding to the shape of the individual semiconductor units 10a to 10c. In addition, the top face 31 is provided with the cooling area 31d. The cooling area 31d includes the unit areas 31a to 31c and has a rectangular shape. In plan view, the cooling area 31d is included in a flow passage area 41, which will be described later, when the top plate 30 is installed on the cooling chassis 40.

On the lower face 32, multiple fins 33 are formed (see FIGS. 7 and 8) . The multiple fins 33 are formed in a region of the lower face 32, corresponding to the cooling area 31d of the top face 31. The multiple fins 33 are individually installed along the lateral faces 30a and 30c and the lateral faces 30b and 30d. The introduced refrigerant moves through flow passages between the multiple fins 33. To this end, the multiple fins 33 are arranged at intervals that do not obstruct the flow of the refrigerant. The multiple fins 33 each have, in the ±Z direction, an upper end (on the +Z direction side) and a lower end (on the -Z direction side). The upper ends of the multiple fins 33 are thermally and mechanically connected to the lower face 32 of the top plate 30. The upper ends of the multiple fins 33 are integrally formed with the lower face 32 of the top plate 30. That is, the multiple fins 33 project from the lower face 32 of the top plate 30 in the -Z direction. Note that, as will be described later, when the top plate 30 with the aforementioned configuration is attached to the cooling chassis 40, the lower ends of the multiple fins 33 have a gap with a flow passage bottom face 41e, which is the bottom of the flow passage area 41 of the cooling chassis 40.

Each of the multiple fins 33 may be a pin fin. In addition, each of the multiple fins 33 has a rectangular cross-section parallel to the lower face 32 of the top plate 30. FIG. 7 illustrates a case where the cross-section is rhombic. This allows the surface area of the multiple fins 33 coming into contact with the refrigerant to be increased compared to the case where the cross-sectional shape of the individual fins 33 is circular, which in turn improves heat dissipation efficiency.

In the X-Y plane of FIG. 7, the multiple fins 33 each form a rhombic shape that is shorter in the direction along the lateral faces 30b and 30d (the transverse direction) than in the direction along the lateral faces 30a and 30c (the longitudinal direction). The cooling device 3 is designed to cause the refrigerant introduced in the +X direction to flow in the ±Y direction, as described later. The aforementioned orientation of the rhombi does not obstruct the flow of the refrigerant. Each corner of the rhombic cross-section may be R-chamfered. Note that the multiple fins 33 may each have a polygonal cross-sectional shape, for example, a square. Alternatively, each of the multiple fins 33 may have a circular cross-sectional shape, for example, a perfect circle. In addition, the multiple fins 33 may be arranged to form a predetermined pattern in the cooling area 31d. FIG. 7 illustrates a case where the multiple fins 33 are arranged in a staggered configuration. Alternatively, the multiple fins 33 may be arranged in a square configuration in the cooling area 31d. In order to direct the refrigerant in the ±Y direction, the multiple fins 33 provided in the cooling device 3 may be flat plate-shaped blade fins, instead of the pin fins, aligned parallel to the lateral faces 30b and 30d.

The top plate 30 with the above-described multiple fins 33 provided thereon is formed, for example, by forging or casting (die-casting). In the case of forging, a block-shaped member containing the aforementioned metal with excellent conductivity as a major component is pressurized using a mold and then plastically deformed to obtain the top plate 30 with the multiple fins 33 formed thereon. In the case of die-casting, a molten die-casting material is poured into a predetermined casting mold and then cooled. After cooling, the casting is removed from the casting mold to obtain the top plate 30 with the multiple fins 33 formed thereon. The die-casting material used here is, for example, an aluminum alloy. Alternatively, the top plate 30 with the multiple fins 33 formed thereon may be made by cutting a block-shaped member whose major component is the aforementioned metal.

The cooling chassis 40 has a rectangular box shape in plan view. The cooling chassis 40 with such a shape includes a top face 40e that is frame-shaped in plan view; and outer lateral faces 40a to 40d that sequentially surround the top face 40e on all four sides.

The outer size of the top face 40e is the same as that of the top plate 30. The flow passage area 41 having a concave shape is formed in the center of the top face 40e. The flow passage area 41 is surrounded by the flow passage bottom face 41e and inner lateral faces 41a to 41d. The flow passage bottom face 41e has a rectangular shape in plan view and is recessed from the top surface 40e (i.e., located in the -Z direction relative to the top face 40e). The flow passage bottom face 41e is substantially parallel to the top face 40e. The inner lateral faces 41a to 41d sequentially surround, in plan view, the flow passage bottom face 41e on all four sides and connect each side of the flow passage bottom face 41e to the top face 40e. The inner lateral faces 41a to 41d correspond to the outer lateral faces 40a to 40d, respectively. In plan view, the inner lateral faces 41a and 41c correspond to the long sides of the flow passage bottom face 41e while the inner lateral faces 41b and 41d correspond to the short sides of the flow passage bottom face 41e. The inner lateral faces 41a to 41d are substantially perpendicular to the flow passage bottom face 41e and the top face 40e. The top face 40e and the inner lateral faces 41a to 41d are each flat and smooth. Each connection part (corner) of the inner lateral faces 41a to 41d as well as each connection part of the inner lateral faces 41a to 41d and the flow passage bottom face 41e may be R-chamfered. The provision of the rounded surfaces ensures that the refrigerant introduced into the flow passage area 41 flows at each of the foregoing connection parts and thus prevents the refrigerant from stagnating at the connection parts, as described below. This in turn prevents the connection parts from corroding due to the refrigerant stagnation at the connection parts.

The top face 40e is provided with a continuous ringshaped sealing member 40f that surrounds the flow passage area 41 in plan view. The sealing member 40f is made of a material having an elastic member as a major component. Rubber is one example of such a material. The sealing member 40f is, for example, an O ring, a packing, or a gasket. The top face 40e is also provided with fastening holes 40g. The fastening holes 40g are individually formed on the top face 40e, in plan view, in the vicinity of each corner of the top face 40e outside the flow passage area 41 and the sealing member 40f. That is, the fastening holes 40g are formed at locations corresponding to the insertion holes 30g when the top plate 30 is set on the top face 40e. Note that the rear surface (not illustrated) opposite the top face 40e is the rear surface of the cooling chassis 40. This rear surface also has a rectangular shape in plan view and is flat and smooth.

Each connection part of the outer lateral faces 40a to 40d as well as each connection part of the outer lateral faces 40a to 40d to the top face 40e may be R-chamfered. In plan view, the outer lateral faces 40a and 40c correspond to the long sides of the top face 40e while the outer lateral faces 40b and 40d correspond to the short sides of the top face 40e. Note that the height of the outer lateral faces 40a to 40d (in the ±Z direction) is, for example, about 30 mm.

The inlet 40h is provided on at least one of the inner lateral face 41b and a lateral face 42b to be described later. An inflow channel 40h1 of the inlet 40h is formed that penetrates the cooling chassis 40 from the inner lateral face 41b to the outer lateral face 40b. In addition, a distribution pipe 44a is connected to the inflow channel 40h1 from the outer lateral face 40b side without a gap. The penetrating direction of the inflow channel 40h1 (and the distribution pipe 44a) is substantially parallel to the inner lateral faces 41a and 41c (the ±X direction, i.e., the longitudinal direction) of the flow passage area 41. The inlet 40h faces an inflow area 42 to be described later. According to the first embodiment, the inlet 40h is formed, on the inner lateral face 41b, at a position closer to the inner lateral face 41c. Accordingly, the inflow channel 40h1 and the distribution pipe 44a are also formed, on the outer lateral face 40b, at a position closer to the outer lateral face 40c. The inlet 40h has, for example, a circular shape. The diameter of the inlet 40h in this case is about 10 mm, for example. Accordingly, the inflow channel 40h1 and the distribution pipe 44a have the same diameter as the inlet 40h.

In addition, an outlet 40i is provided on the inner lateral face 41d. An outflow channel 40i1 of the outlet 40i is formed that penetrates the cooling chassis 40 from the inner lateral face 41d to the outer lateral face 40d. In addition, a distribution pipe 44b is connected to the outflow channel 40i1 from the outer lateral face 40d side without a gap. The penetrating direction of the outflow channel 40i1 (and the distribution pipe 44b) is substantially parallel to the inner lateral faces 41a and 41c (the ±X direction, i.e., the longitudinal direction) of the flow passage area 41. According to the first embodiment, the outlet 40i is formed, on the inner lateral face 41d, at a position closer to the inner lateral face 41a. Accordingly, the outflow channel 40i1 and the distribution pipe 44b are also formed, on the outer lateral face 40d, at a position closer to the outer lateral face 40a. Note however that the outlet 40i may be formed near the corner on the opposite side to the inlet 40h across the center of the flow passage area 41. Therefore, the outlet 40i may be formed, on the inner lateral face 41a, at a position closer to the inner lateral face 41d. With respect to the position where the outlet 40i is provided, the outflow channel 40i1 and the distribution pipe 44b may also be formed, on the outer lateral face 40a, at a position closer to the outer lateral face 40d. The outlet 40i has, for example, a circular shape. The diameter of the outlet 40i in this case is about 10 mm, for example. Accordingly, the outflow channel 40i1 and the distribution pipe 44b have the same diameter as the outlet 40i.

In addition, the inflow area 42 is formed on the flow passage bottom face 41e of the cooling chassis 40. The inflow area 42 is formed in the vicinity of the inlet 40h of the flow passage bottom face 41e in plan view. The inflow area 42 is recessed in a concave shape from the flow passage bottom face 41e, and communicates with the inlet 40h.

The inflow area 42 is surrounded by an inflow bottom face 42e, lateral faces 42a to 42c, and the diffusion face 42d. The inflow bottom face 42e is recessed from the flow passage bottom face 41e (located in the -Z direction relative to the flow passage bottom face 41e) and has a rectangular shape in plan view. The inflow bottom face 42e is substantially parallel to the flow passage bottom face 41e.

The lateral faces 42a to 42c and the diffusion face 42d sequentially surround, in plan view, the inflow bottom face 42e on all four sides, and connect each side of the inflow bottom face 42e to the flow passage bottom face 41e. Note that, according to the first embodiment, the inflow area 42 is formed, relative to the flow passage area 41, in the vicinity of the corner formed by the inner lateral faces 41b and 41c in plan view. Accordingly, the lateral faces 42b and 42c of the inflow area 42 are flush with the inner lateral faces 41b and 41c, respectively. Therefore, the lateral face 42a and the diffusion face 42d connect the inflow bottom face 42e and the flow passage bottom face 41e. In plan view, the lateral faces 42a and 42c correspond to the long sides of the inflow bottom face 42e while the lateral face 42b and the diffusion face 42d correspond to the short sides of the inflow bottom face 42e.

The lateral faces 42a to 42c and the diffusion face 42d are substantially perpendicular to the inflow bottom face 42e and the flow passage bottom face 41e. That is, the lateral faces 42a to 42c and the diffusion face 42d are substantially perpendicular to a plane substantially parallel to the top face 31 of the top plate 30. Note that the lateral face 42a may be at an angle of 90° or more and 125° or less to the inflow bottom face 42e. That is, the lateral face 42a may be at an angle of 90° or more and 125° or less to the transverse direction (the - Y direction). When the lateral face 42a is at an angle of less than 90° to the inflow bottom face 42e, the refrigerant flowing through the inflow area 42 becomes difficult to flow from the inflow area 42 to the flow passage bottom face 41e. On the other hand, if the lateral face 42a is at an angle of more than 125° to the inflow bottom face 42e, when the top plate 30 is attached to the cooling chassis 40, the refrigerant may fail to hit the multiple fins 33 on the inner lateral face 41c side, as described below.

In addition, the diffusion face 42d may preferably be perpendicular to the inflow bottom face 42e and the flow passage bottom face 41e. Note that the diffusion face 42d may be inclined in side view (i.e., when viewed in the ±Y direction). The inclination in this case is, for example, 85° or more and 95° or less. That is, the diffusion face 42d is inclined at an angle of 85° or more and 95° or less to a plane substantially parallel to the top face 31 of the top plate 30.

The inflow bottom face 42e, the lateral faces 42a to 42c, and the diffusion face 42d are individually flat and smooth. In addition, each connection part (corner) of the lateral faces 42a to 42c and the diffusion face 42d to each other as well as each connection part of the lateral faces 42a to 42c and the diffusion face 42d to the inflow bottom face 42e may be R-chamfered. The provision of the rounded surfaces ensures that the refrigerant introduced into the inflow area 42 flows at each connection part and thus prevents the refrigerant from stagnating at the connection parts, as described below. This in turn prevents the connection parts from corroding due to the refrigerant stagnation at the connection parts.

In addition, the diffusion face 42d preferably faces the inlet 40h, as illustrated in FIGS. 9 and 10. The size of the diffusion face 42d simply needs to be larger than the area of the inlet 40h. The length (in the ±Z direction) and width (in the ±Y direction) of the diffusion face 42d may be, for example, about equal to the diameter of the inlet 40h, as illustrated in FIGS. 9 and 10.

A length L2 spanning from the inlet 40h to the diffusion face 42d may be about one third of a length L1 of the individual inner lateral faces 41a and 41c of the flow passage area 41 (the length from the inlet 40h to the inner lateral face 41d). If being too close to the inlet 40h, the diffusion face 42d blocks the inlet 40h. In this case, the refrigerant introduced from the inlet 40h becomes clogged at the diffusion face 42d and is difficult to properly spread in the flow passage area 41. On the other hand, if the diffusion face 42d is too far away from the inlet 40h, the flow of the refrigerant introduced from the inlet 40h significantly stalls before reaching the diffusion face 42d. In this case, even if having reached the diffusion face 42d, the refrigerant is not sufficiently diffused by the diffusion face 42d, which is thus ineffective. In view of the above, the length L2 associated with the diffusion face 42d may preferably be 5% or more and 30% or less of the length L1, and more preferably 5% or more and 15% or less. For example, when the length L1 is 120 mm, the length L2 may preferably be 30 mm, and more preferably 15 mm.

Note that the inlet 40h may be parallel to the diffusion face 42d and partially overlap the diffusion face 42d when viewed in the +X direction. For example, as illustrated in FIG. 11, the inlet 40h is located upward (in the +Z direction) from the diffusion face 42d, and the lower part of the inlet 40h overlaps the diffusion face 42d when viewed in the X direction. Not limited to this case, the inlet 40h may be located to the left or right (in the +Y or -Y direction) with respect to the diffusion face 42d so that the left or right part of the inlet 40h overlaps the diffusion face 42d when viewed in the X direction.

The cooling chassis 40 described above is formed, for example, by forging or casting (die-casting). In the case of forging, a block-shaped member containing the aforementioned metal with excellent conductivity as a major component is pressurized using a mold and then plastically deformed to obtain the cooling chassis 40. In the case of die-casting, a molten die-casting material is poured into a predetermined casting mold and then cooled. After cooling, the casting is removed from the casting mold to obtain the cooling chassis 40. The die-casting material used here is, for example, an aluminum alloy. Alternatively, the cooling chassis 40 may be made by cutting a block-shaped member whose major component is the aforementioned metal. In addition, the distribution pipes 44a and 44b may be manufactured separately and joined to the inflow channel 40h1 and the outflow channel 40i1 of the cooling chassis 40 by welding.

The lower face 32 of the top plate 30 is attached to the top face 40e of the cooling chassis 40 with the above-described configuration (see, for example, FIG. 8). The sealing member 40f is held between the top face 40e and the lower face 32 of the top plate 30, thereby sealing the gap between the top face 40e and the lower face 32 of the top plate 30. Herewith, the flow passage area 41 of the cooling chassis 40 is closed by the top plate 30. The refrigerant in the flow passage area 41 is prevented from leaking to the outside. In addition, the multiple fins 33 are housed in the flow passage area 41 of the cooling chassis 40. In this manner, the cooling device 3 is configured. A pump is connected to the distribution pipes 44a and 44b of the cooling device 3. The pump causes the refrigerant to flow into the flow passage area 41 from the inlet 40h via the distribution pipe 44a. After having circulated through the multiple fins 33 in the flow passage area 41 of the cooling device 3, the refrigerant flows out from the outlet 40i, and is then redirected by the pump to the flow passage area 41 of the cooling device 3 from the inlet 40h via the distribution pipe 44a. Note that the flow passages of the refrigerant in the flow passage area 41 will be described later.

Note that the inlet 40h (as well as the inflow channel 40h1 and the distribution pipe 44a) and the outlet 40i (as well as the outflow channel 40i1 and the distribution pipe 44b) may be swapped to configure the cooling device 3. That is, the outlet 40i may be provided, on the inner lateral face 41a, at a position closer to the inner lateral face 41b while the outlet 40i may be provided, on the inner lateral face 41d, at a position closer to the inner lateral face 41a. In this case, the inflow area 42 is also provided in such a manner as to include the inlet 40h near the corner formed by the inner lateral faces 41a and 41d of the flow passage area 41.

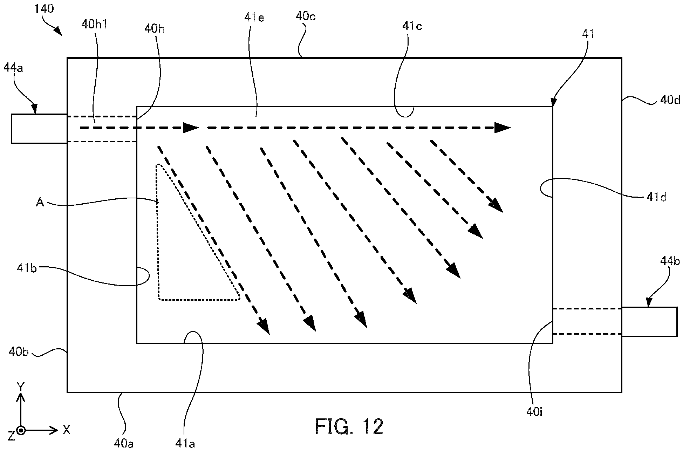

Here, as a reference example, the cooling device 3 (cooling chassis) with no inflow area 42 formed therein is described using FIG. 12. FIG. 12 illustrates flow passages of a refrigerant of the cooling device included in a semiconductor device of the reference example. Note that FIG. 12 is a plan view of a cooling chassis 140 with the top plate 30 removed from the cooling device 3. The cooling chassis 140 is configured without the inflow area 42 provided in the cooling chassis 40. That is, the entire flow passage bottom face 41e of the flow passage area 41 in the cooling chassis 140 lies on the same plane. The broken line arrows in FIG. 12 represent the flow of the refrigerant.

When introduced from the distribution pipe 44a of the cooling chassis 140, the refrigerant moves through the distribution pipe 44a and the inflow channel 40h1 and then flows into the flow passage area 41 from the inlet 40h. That is, the refrigerant flows into the flow passage area 41 as travelling parallel to the inner lateral faces 41a and 41c (in the +X direction, i.e., the longitudinal direction).

The refrigerant having flowed in from the inlet 40h moves in the X direction and the -Y direction (toward the vicinity of the corner formed by the inner lateral faces 41a and 41d) as traveling in the flow passage area 41 in the +X direction to thus spread inside the flow passage area 41. Then, the refrigerant spreads toward the outlet 40i.

However, because the refrigerant spreads inside the flow passage area 41 in plan view in the above-described manner, it is difficult to flow through a region A surrounded by the broken line in FIG. 12. As a result, cooling performance over the top face 31 of the top plate 30 in the cooling device 3 (the cooling chassis 140) varies depending on the position. That is, the semiconductor module 2 is properly cooled within the half of the flow passage area 41 in the +X direction in plan view. However, the cooling performance for the semiconductor module 2 is reduced over the region A (the vicinity of the inlet 40h) of the flow passage area 41 in plan view.

Thus, variations in cooling performance occur on the top face 31 of the top plate 30 of the cooling device 3 that includes the cooling chassis 140. This prevents proper cooling of the semiconductor module 2 disposed on the cooling device 3.

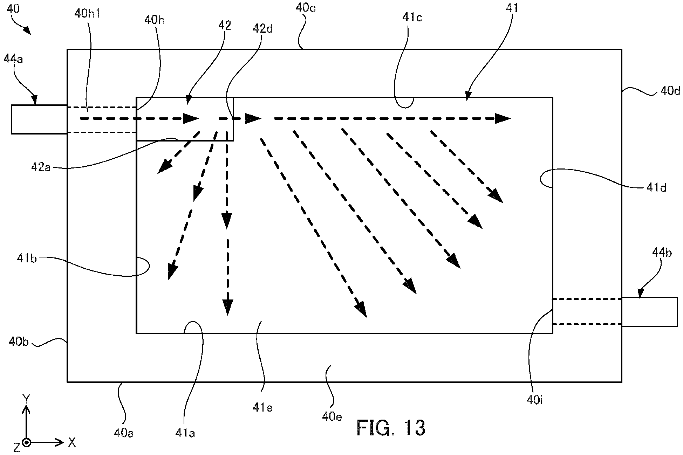

Next described is the flow of the refrigerant of the cooling device 3 according to the first embodiment, with reference to FIG. 13. FIG. 13 illustrates the flow of the refrigerant of the cooling device included in the semiconductor device of the first embodiment. Note that FIG. 13 is a plan view of the cooling chassis 40 with the top plate 30 removed from the cooling device 3, as in FIG. 12. Also in FIG. 13, the broken line arrows represent the flow of the refrigerant.

When introduced from the distribution pipe 44a of the cooling chassis 40, the refrigerant moves through the distribution pipe 44a and the inflow channel 40h1 and then flows into the inflow area 42 from the inlet 40h. That is, the refrigerant flows into the inflow area 42 as travelling parallel to the inner lateral faces 41a and 41c (in the +X direction, i.e., the longitudinal direction).

When moving straight through the inflow area 42 in the +X direction, the refrigerant hits the diffusion face 42d. A part of the refrigerant goes over the diffusion face 42d and proceeds directly to the inner lateral face 41d. In addition, a part of the refrigerant having hit the diffusion face 42d is diffused by the diffusion face 42d. The diffused refrigerant spreads from the diffusion face 42d in the -Y direction (toward the inner lateral face 41a and the outer lateral face 40a) as well as in the -Y and -X direction (toward the vicinity of the corner formed by the inner lateral faces 41a and 41b (the outer lateral faces 40a and 40b)). That is, the refrigerant flows through the region A of FIG. 12. The refrigerant that has thus proceeded to the inner lateral faces 41a and 41b then moves toward the outlet 40i.

The refrigerant passing beyond the diffusion face 42d and proceeding directly to the inner lateral face 41d travels straight in the +X direction within the flow passage area 41 and also moves in the X and -Y direction (toward the corner formed by the inner lateral faces 41a and 41d), to thus spread inside the flow passage area 41. Then, the refrigerant spreads toward the outlet 40i.

In light of the above, even if the inlet 40h (and the distribution pipe 44a) and the outlet 40i (and the distribution pipe 44b) are provided on the inner lateral face 41b (and the outer lateral face 40b) and the inner lateral face 41d (and the outer lateral face 40d), which are the short sides, variations in cooling performance depending on the position on the top plate 30 of the cooling device 3 do not occur and, therefore, uniform cooling performance is achieved and the problem of reduced cooling performance is thus improved. As a result, vacant space is created on the sides of the outer lateral faces 40a and 40c of the cooling device 3. That is, while improving the problem of reduced cooling performance of the cooling device 3, it is possible to place a capacitor on either side of the outer lateral faces 40a and 40c of the cooling device 3. The capacitor allows to be placed adjacent to the semiconductor module 2, which facilitates connection of the capacitor and the semiconductor module 2.

The general flow route of the refrigerant having flowed into the flow passage area 41 from the inlet 40h is such that the refrigerant enters the flow passage area 41 as travelling parallel to the inner lateral faces 41a and 41c (in the +X direction, i.e., the longitudinal direction), and spreads parallel to the inner lateral faces 41b and 41d (in the -Y direction, i.e., the transverse direction) within the flow passage area 41. Because the refrigerant proceeds in the transverse direction when it spreads inside the flow passage area 41, the refrigerant spreads over the flow passage area 41 while reducing pressure drop.

The refrigerant introduced from the inlet 40h moves through flow passages between the multiple fins 33 in the flow passage area 41 and then flows out from the outlet 40i. Herewith, the semiconductor module 2 disposed on the cooling device 3 is cooled.

The above semiconductor device 1 includes the semiconductor chips 12; and the cooling device 3 on which the semiconductor chips 12 are mounted. The cooling device 3 includes the top plate 30 including the top face 31 on which the semiconductor chips 12 are placed and the lower face 32 opposite the top face 31; and the cooling chassis 40. In the cooling chassis 40, the flow passage area 41 is formed on the top face 40e having a rectangular shape in plan view and surrounded on all four sides sequentially by the outer lateral faces 40a to 40d. The flow passage area 41 has a concave shape and includes the flow passage bottom face 41e recessed from the top face 40e. The lower face 32 of the top plate 30 is disposed on the top face 40e to thereby close the flow passage area 41 with the top plate 30. In addition, in plan view, the cooling chassis 40 has the outer lateral faces 40a and 40c spanning the long sides and the outer lateral faces 40b and 40d spanning the short sides. On the outer lateral face 40b, at a position closer to the outer lateral face 40c, the inlet 40h communicating with the flow passage area 41 is formed on the inner lateral face 41c corresponding to the outer lateral face 40c. A medium is introduced and flows through the inlet 40h in the longitudinal direction toward the flow passage area 41. In addition, the inflow area 42 is formed, on the flow passage bottom face 41e, at a position closer to the inlet 40h. The inflow area 42 is recessed in a concave shape from the flow passage bottom face 41e and communicates with the inlet 40h. The inflow area 42 includes the diffusion face 42d opposing the inlet 40h.

Herewith, the refrigerant introduced from the inlet 40h moves straight through the inflow area 42 in the +X direction and then hits the diffusion face 42d. A part of the refrigerant goes over the diffusion face 42d and proceeds directly to the inner lateral face 41d. In addition, a part of the refrigerant having hit the diffusion face 42d is diffused by the diffusion face 42d. The diffused refrigerant spreads from the diffusion face 42d toward the outer lateral face 40a as well as toward the vicinity of the corner formed by the outer lateral faces 40a and 40b. The refrigerant having travelled in this manner then proceeds toward the outlet 40i. The refrigerant having gone over the diffusion face 42d and proceeded directly to the inner lateral face 41d moves straight in the +X direction in the flow passage area 41 and also proceeds to the vicinity of the corner formed by the inner lateral faces 41a and 41d to hereby spread inside the flow passage area 41. The refrigerant eventually spreads toward the outlet 40i. Therefore, the refrigerant flows throughout the flow passage area 41, which suppresses variations in cooling performance depending on the position on the top plate 30 of the cooling device 3 and enables uniform cooling over the top plate 30. In addition, the semiconductor device 1 has the inlet 40h on the outer lateral face 40b, which allows the capacitor to be installed on the side of the outer lateral face 40a or 40c of the cooling device 3, adjacent to the semiconductor chips 12. Therefore, in the semiconductor device 1, it is possible to install the capacitor in an area suitable for the semiconductor chips 12 and improve the problem of reduced cooling performance of the cooling device 3, thereby preventing decreased reliability of the semiconductor device 1.

### Modification 1-1

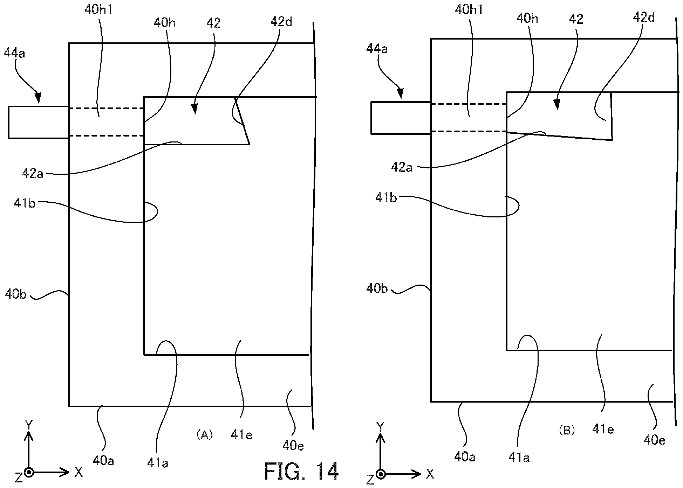

In Modification 1-1, a modification of the inflow area 42 included in the cooling device 3 described above is explained with reference to FIG. 14. FIG. 14 is plan views each illustrating the cooling chassis of the cooling device included in the semiconductor device of the first embodiment (Modification 1-1). Note that FIG. 14 provides enlarged views of the vicinity of the inflow area 42 of FIG. 13.

The diffusion face 42d may be inclined at an acute angle to the lateral face 42a in plan view, as illustrated in (A) of FIG. 14. That is, the diffusion face 42d may be inclined at an acute angle to the longitudinal direction (the +X direction). The refrigerant having hit the inclined diffusion face 42d and been diffused more reliably spreads from the diffusion face 42d toward the inner lateral face 41a (the outer lateral face 40a) as well as toward the vicinity of the corner formed by the inner lateral faces 41a and 41b (the outer lateral faces 40a and 40b). Note however that when the inclination angle of the diffusion face 42d is too large (the diffusion face 42d is inclined at an obtuse angle to the longitudinal direction), it may be difficult for the introduced refrigerant to move straight in the +X direction. For this reason, it is preferable that the inclination angle be, for example, 80° or more and 90° or less. That is, the diffusion face 42d may preferably have an inclination angle of 80° or more and 90° or less to the longitudinal direction (the +X direction).

In addition, the lateral face 42a may be inclined at an acute angle to the diffusion face 42d in plan view, as illustrated in (B) of FIG. 14. That is, the lateral face 42a may be inclined at an acute angle to the transverse direction (the -Y direction). The refrigerant introduced from the inlet 40h advances through the inflow area 42 which expands as it moves in the +X direction, and then hits the diffusion face 42d and is diffused, as in the first embodiment. The diffused refrigerant spreads from the diffusion face 42d toward the inner lateral face 41a (the outer lateral face 40a) as well as toward the vicinity of the corner formed by the inner lateral faces 41a and 41b (the outer lateral faces 40a and 40b). Note however that when the inclination angle of the lateral face 42a is too large (the lateral face 42a is inclined at an obtuse angle to the transverse direction), the flow of the introduced refrigerant may stall. For this reason, the inclination angle is set, for example, to 80° or more and 90° or less. That is, the lateral face 42a has an inclination angle of 80° or more and 90° or less to the transverse direction (the -Y direction). Note that in the inflow area 42, both the diffusion face 42d and the lateral face 42a may be individually inclined as depicted in (A) and (B) of FIG. 14.

### Modification 1-2

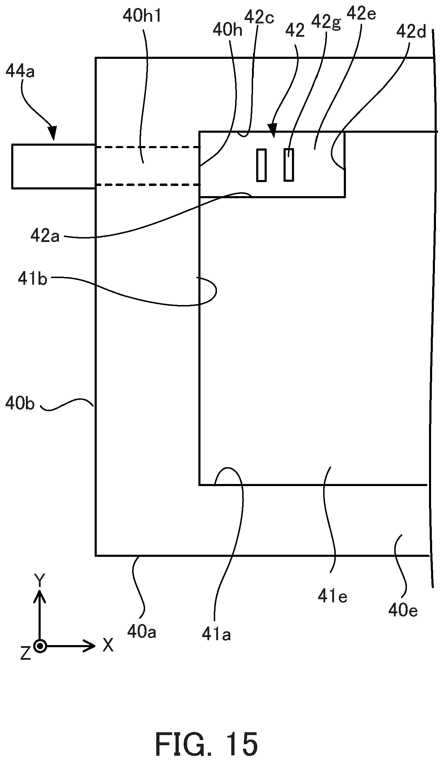

In Modification 1-2, a modification of the inflow area 42 included in the cooling device 3 described above is explained with reference to FIG. 15. FIG. 15 is a plan view of the cooling chassis of the cooling device included in the semiconductor device of the first embodiment (Modification 1-2). Note that FIG. 15 provides an enlarged view of the vicinity of the inflow area 42 of FIG. 13.

Guide walls 42g are formed on the inflow bottom face 42e of the inflow area 42 of the cooling chassis 40 according to Modification 1-2. The guide walls 42g are formed to extend in the +Z direction with respect to the inflow bottom face 42e. The guide walls 42g may each have a surface opposing the inner lateral face 41b (the inlet 40h). The guide walls 42g may be inclined in the same manner as the diffusion face 42d.

The refrigerant introduced from the inlet 40h moves straight through the inflow area 42 in the +X direction. At this time, a part of the refrigerant is guided in the -Y direction by the guide walls 42g. Therefore, the refrigerant more reliably spreads from the inflow area 42 toward the inner lateral face 41a (the outer lateral face 40a) as well as toward the vicinity of the corner formed by the inner lateral faces 41a and 41b (the outer lateral faces 40a and 40b), compared to the case where only the diffusion face 42d is provided in the inflow area 42.

Note that the guide walls 42g of FIG. 15 each have a flat plate shape; however, their shape is not limited to a flat plate as long as the guide walls 42g have surfaces parallel to and opposing the inner lateral face 41b (the inlet 40h). For example, as long as the aforementioned surfaces are provided, the guide walls 42g may have a block or hemispherical shape. In addition, FIG. 15 depicts a case where two guide walls 42g are formed; however, the number of guide walls is not limited to two, and may be one, or three or more. If the guide walls 42g are too close to the inlet 40h, the guide walls 42g block the inlet 40h, thereby impeding the inflow of the refrigerant. Therefore, as for the guide wall 42g closest to the inlet 40h, the length from the inlet 40h to the guide wall 42g closest to the inlet 40h needs to be 5% or more of the length L1, and the guide wall 42g closest to the inlet 40h is located closer to the inlet 40h than the diffusion face 42d.

The guide walls 42g of FIG. 15 are formed at the center of the inflow bottom face 42e of the inflow area 42 in the ±Y direction. However, where the guide walls 42g are installed is not limited to this example, and the guide walls 42g may be formed, on the inflow bottom face 42e, in contact with either of the lateral faces 42a and 42c. Alternatively, the guide walls 42g may be formed in a staggered manner against the lateral faces 42a and 42c.

If the width of the guide walls 42g in the ±Y direction is about the same as the width of the diffusion face 42d in the same direction, the guide walls 42g prevent most of the refrigerant from moving straight. In addition, if the width of the guide walls 42g in the ±Y direction is too narrow compared to the width of the diffusion face 42d in the same direction, the guiding effect on the refrigerant is reduced. In view of the above, the width of the guide walls 42g in the ±Y direction may be 45% or more and 55% or less, for example, 50%, of the width of the diffusion face 42d in the same direction.

### [Second Embodiment]

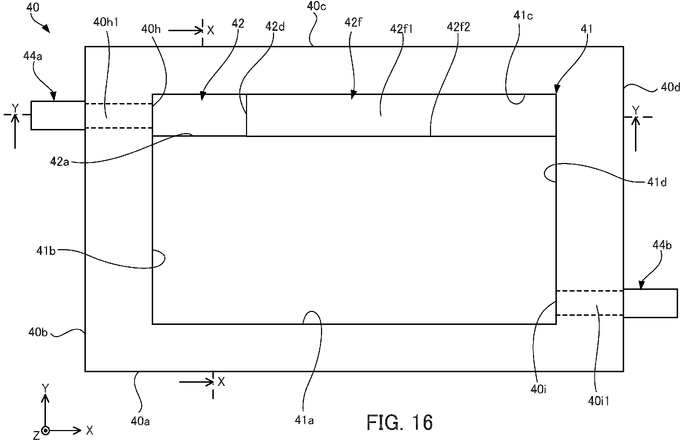

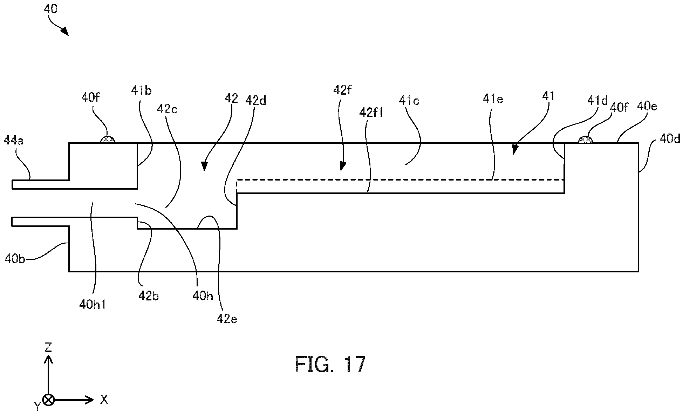

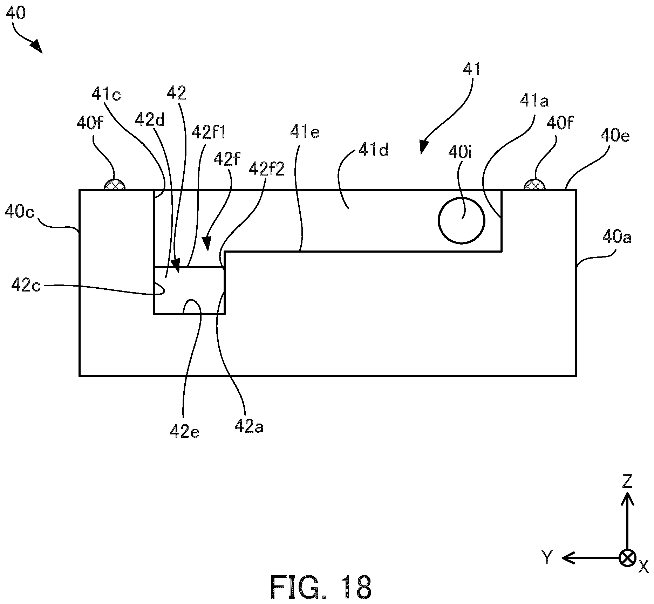

The cooling chassis 40 of the cooling device 3 according to a second embodiment is described using FIGS. 16 to 18. FIG. 16 is a plan view of the cooling chassis of the cooling device included in a semiconductor device of the second embodiment. FIGS. 17 and 18 are cross-sectional views of the cooling chassis of the cooling device included in the semiconductor device of the second embodiment.

The cooling chassis 40 of the second embodiment differs from the cooling chassis 40 of the first embodiment in having a groove part 42f therein. The configuration of the cooling chassis 40 of the second embodiment is the same as that of the cooling chassis 40 of the first embodiment other than the groove part 42f.

The groove part 42f is formed in the flow passage area 41 in such a manner as to extend, in plan view, from the diffusion face 42d of the inflow area 42 to the inner lateral face 41d along the inner lateral face 41c (in the +X direction, that is, the longitudinal direction). The width of the groove part 42f in the ±Y direction is equal to the width of the inflow area 42 in the same direction. In addition, the groove part 42f is defined by a groove bottom face 42f1, a groove lateral face 42f2, and the inner lateral faces 41c and 41d.

The groove bottom face 42f1 is connected to the diffusion face 42d, extends along the inner lateral face 41c (in the longitudinal direction) toward the inner lateral face 41d, and is then connected to the inner lateral face 41d. The groove bottom face 42f1 is located, in the ±Z direction, lower than the flow passage bottom face 41e and higher than the inflow bottom face 42e. In addition, the groove bottom face 42f1 is substantially parallel to the flow passage bottom face 41e and the inflow bottom face 42e. The entire groove bottom face 42f1 is flat and smooth. Note that if the depth of the groove bottom face 42f1 from the flow passage bottom face 41e is too sharrow, the refrigerant does not travel straight along the groove part 42f. On the other hand, if it is too deep, the refrigerant traveling straight in the groove part 42f becomes difficult to flow out to the flow passage area 41. Therefore, the depth of the groove bottom face 42f1 from the flow passage bottom face 41e may preferably be 10% or more of the depth of the inflow bottom face 42e from the flow passage bottom face 41e.

The groove lateral face 42f2 extends to the inner lateral face 41d, running parallel to the inner lateral face 41c (in the longitudinal direction). The groove lateral face 42f2 connects the groove bottom face 42f1 to the flow passage bottom face 41e. Note that the second embodiment depicts a case where the groove lateral face 42f2 is perpendicular to the groove bottom face 42f1 and the flow passage bottom face 41e; however, the groove lateral face 42f2 may be inclined at an obtuse angle to the groove bottom face 42f1. That is, the groove lateral face 42f2 may be inclined at an obtuse angle to the transverse direction. This prevents eddy currents from being possibly induced when the groove lateral face 42f2 is perpendicular to the groove bottom face 42f1. Note however that if the inclination is too large, there is a risk that the refrigerant flowing out from the groove lateral face 42f2 may fail to hit the multiple fins 33. For this reason, the inclination angle is, for example, greater than 90° and less than or equal to 125°. That is, the groove lateral face 42f2 has an inclination angle of greater than 90° and less than or equal to 125° to the transverse direction.

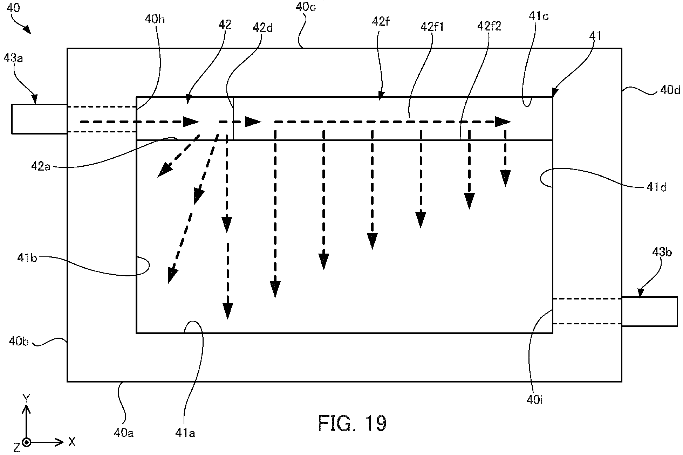

Next described is the flow of the refrigerant of the cooling device 3 according to the second embodiment, with reference to FIG. 19. FIG. 19 illustrates the flow of the refrigerant of the cooling device included in the semiconductor device of the second embodiment. Note that FIG. 19 is a plan view of the cooling chassis 40 with the top plate 30 removed from the cooling device 3, as in FIG. 16. Also in FIG. 19, the broken line arrows represent the flow of the refrigerant.

When introduced from the distribution pipe 44a of the cooling chassis 40, the refrigerant moves through the distribution pipe 44a and the inflow channel 40h1 and then flows into the inflow area 42 from the inlet 40h. That is, the refrigerant flows into the inflow area 42 as travelling parallel to the inner lateral faces 41a and 41c (in the +X direction, i.e., the longitudinal direction).

A part of the refrigerant then hits the diffusion face 42d and is diffused by the diffusion face 42d, as in the first embodiment. The diffused refrigerant spreads from the diffusion face 42d in the -Y direction (toward the inner lateral face 41a and the outer lateral face 40a) as well as in the -Y and -X direction (toward the vicinity of the corner formed by the inner lateral faces 41a and 41b (the outer lateral faces 40a and 40b)). That is, the refrigerant flows through the region A of FIG. 12. The refrigerant that has thus proceeded to the inner lateral faces 41a and 41b then moves toward the outlet 40i.

In addition, the refrigerant having flowed into the inflow area 42 passes beyond the diffusion face 42d and proceeds directly to the inner lateral face 41d. The refrigerant flowing in the +X direction beyond the diffusion face 42d moves straight inside the groove part 42f toward the inner lateral face 41d. During this time, a part of the refrigerant flows out from the groove part 42f over the groove lateral face 42f2 in the -Y direction toward the inner lateral face 41a.

The refrigerant having reached the inner lateral face 41d then flows toward the inner lateral face 41a along the inner lateral face 41d (in the -Y direction, i.e., the transverse direction) and eventually flows out from the outlet 40i. After the refrigerant flowing out from the groove part 42f travels toward and reaches the inner lateral face 41a, the refrigerant then moves toward the inner lateral face 41d along the inner lateral face 41a and flows out from the outlet 40i.

In the cooling chassis 40 of the second embodiment, the refrigerant diffused by the diffusion face 42d spreads from the diffusion face 42d in the -Y direction (toward the inner lateral face 41a and the outer lateral face 40a) as well as in the -Y and -X direction (toward the vicinity of the corner formed by the inner lateral faces 41a and 41b (the outer lateral faces 40a and 40b)), as in the first embodiment. Further, the provision of the groove part 42f facilitates the refrigerant travelling through the groove part 42f to be distributed inside the flow passage area 41 from the inner lateral face 41c toward the inner lateral face 41a along the inner lateral face 41d (in the transverse direction). Therefore, the cooling chassis 40 of the second embodiment is able to spread the refrigerant better throughout the flow passage area 41 than in the first embodiment. Thus, it is possible to further suppress variations in cooling performance depending on the position on the top face 31 of the top plate 30 provided on the cooling chassis 40 and, therefore, uniform cooling performance is achieved. In this manner, the problem of reduced cooling performance is improved even more.

### Modification 2-1

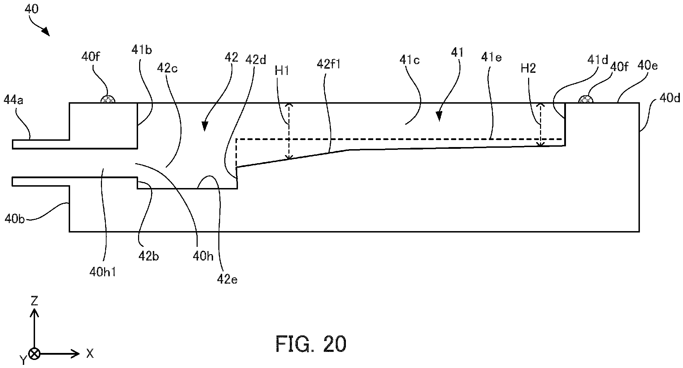

In Modification 2-1, a modification of the groove bottom face 42f1 of the groove part 42f included in the aforementioned cooling device 3 is explained with reference to FIG. 20. FIG. 20 is a cross-sectional view of the cooling chassis of the cooling device included in the semiconductor device of the second embodiment (Modification 2-1). Note that FIG. 20 corresponds to FIG. 17. The cooling chassis 40 of Modification 2-1 has the same configuration as the cooling chassis 40 of the second embodiment except for the groove part 42f.

As in the second embodiment, the groove bottom face 42f1 of the groove part 42f included in the cooling chassis 40 of Modification 2-1 is connected to the diffusion face 42d, extends along the inner lateral face 41c (in the longitudinal direction), and is then connected to the inner lateral face 41d. At this time, the groove bottom face 42f1 is sloped upward toward the inner lateral face 41d. That is, the groove bottom face 42f1 is located higher on the inner lateral face 41d side than on the diffusion face 42d side. For example, according to FIG. 20, a height H1 spanning from the groove bottom face 42f1 on the diffusion face 42d side to the top face 40e is greater than a height H2 spanning from the groove bottom face 42f1 on the inner lateral face 41d side to the top face 40e. The groove bottom face 42f1 simply needs to rise toward the inner lateral face 41d. The groove bottom face 42f1 of FIG. 20 rises as it moves in the +X direction from the diffusion face 42d. The groove bottom face 42f1 continues to ascend from a certain position with a smaller inclination angle. In this way, there may be multiple points at which the inclination angle changes midway. Alternatively, the groove bottom face 42f1 may rise in a curved pattern.

The refrigerant is also introduced into the cooling chassis 40 including the groove part 42f with the above configuration in the same manner as described above. The refrigerant passes through the distribution pipe 44a and the inflow channel 40h1 and then flows into the inflow area 42 from the inlet 40h. The refrigerant flows into the inflow area 42 as travelling parallel to the inner lateral faces 41a and 41c (in the +X direction, i.e., the longitudinal direction).

A part of the refrigerant then hits the diffusion face 42d and is diffused by the diffusion face 42d, as in the first embodiment. The diffused refrigerant spreads from the diffusion face 42d in the -Y direction (toward the inner lateral face 41a and the outer lateral face 40a) as well as in the -Y and -X direction (toward the vicinity of the corner formed by the inner lateral faces 41a and 41b (the outer lateral faces 40a and 40b)).

In addition, the refrigerant having flowed into the inflow area 42 passes beyond the diffusion face 42d and proceeds inside the groove part 42f toward the inner lateral face 41d. At this time, the height H2 is less than the height H1. In the groove part 42f, the refrigerant is more difficult to flow on the inner lateral face 41d side than on the diffusion face 42d side. This configuration, therefore, facilitates the refrigerant to flow out from the entire (longitudinal direction of) groove part 42f toward the inner lateral face 41a. Thereby, it is possible to reduce the difference in flow velocity across the flow passage area 41, i.e., the flow velocity difference among the inner lateral face 41b side, the inner lateral face 41d side, and the central region of the flow passage area 41. In this manner, the cooling chassis 40 of Modification 2-1 allows the refrigerant to spread better throughout the flow passage area 41 than in the second embodiment.

Note that, also in the inflow area 42 of the second embodiment, at least one of the diffusion face 42d and the lateral face 42a may be inclined, as described in Modification 1-1. In addition, the guide walls 42g may be formed in the inflow area 42 of the second embodiment, as described in Modification 1-2.

### [Third Embodiment]

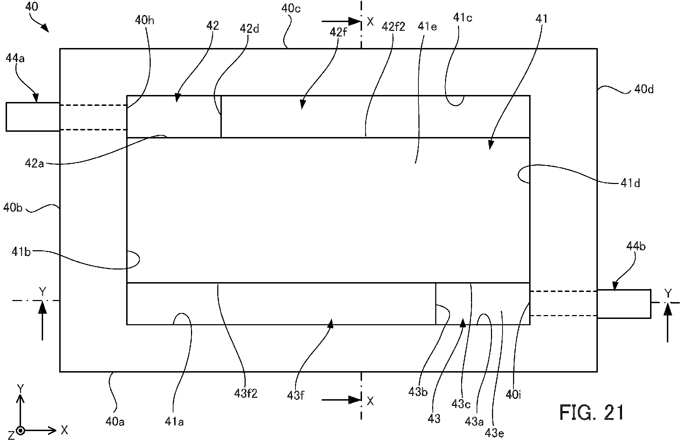

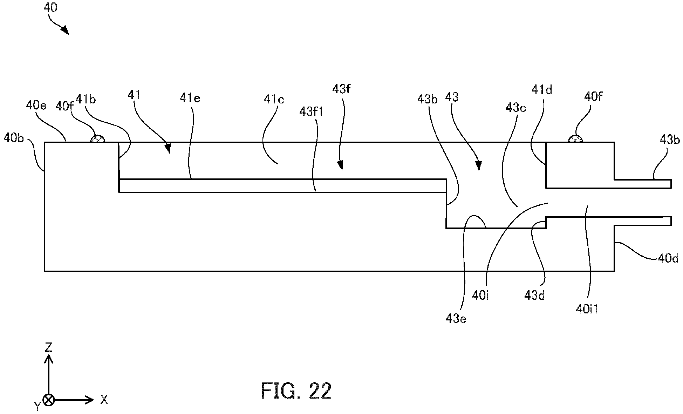

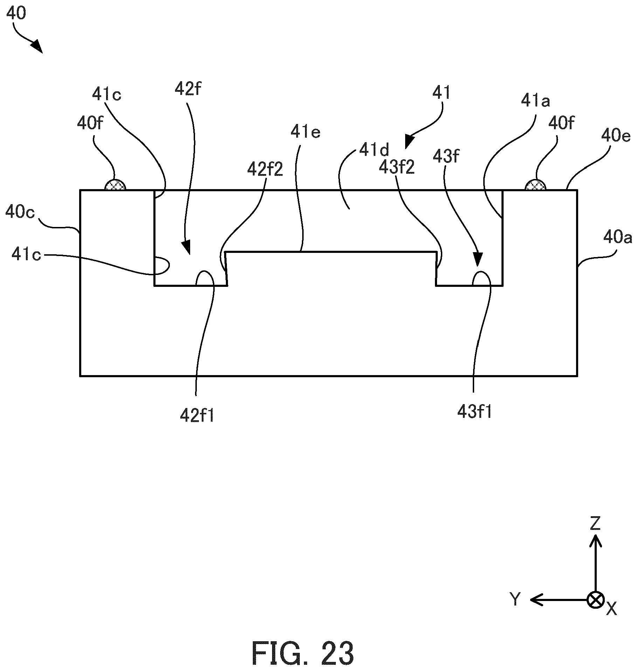

Next described is the cooling device 3 (the cooling chassis 40) according to a third embodiment, with reference to FIGS. 21 to 23. FIG. 21 is a plan view of the cooling chassis of the cooling device included in a semiconductor device of the third embodiment. FIGS. 22 and 23 are cross-sectional views of the cooling chassis of the cooling device included in the semiconductor device of the third embodiment. Note that the cross-sectional view of FIG. 22 is taken along dashed-dotted line Y-Y of FIG. 21 while the cross-sectional view of FIG. 23 is taken along dashed-dotted line X-X of FIG. 21.

The cooling chassis 40 of the third embodiment differs from the cooling chassis 40 of the second embodiment in having, on the outlet 40i side, an outflow area 43 corresponding to the inflow area 42 and a groove part 43f corresponding to the groove part 42f.

The outflow area 43 is surrounded by an outflow bottom face 43e and lateral faces 43a to 43d. The outflow bottom face 43e is recessed from the flow passage bottom face 41e (located in the -Z direction relative to the flow passage bottom face 41e) and has a rectangular shape in plan view. The outflow bottom face 43e is substantially parallel to the flow passage bottom face 41e.

The lateral faces 43a to 43d sequentially surround the outflow bottom face 43e on all four sides in plan view, and connect each side of the outflow bottom face 43e to the flow passage bottom face 41e. Note that, according to the third embodiment, the outflow area 43 is formed, relative to the flow passage area 41, in the vicinity of the corner formed by the inner lateral faces 41a and 41d in plan view. Accordingly, the lateral faces 43a and 43d of the outflow area 43 are flush with the inner lateral faces 41a and 41d, respectively. Therefore, the lateral faces 43b and 43c connect the outflow bottom face 43e and the flow passage bottom face 41e. In plan view, the lateral faces 43a and 43c correspond to the long sides of the outflow bottom face 43e while the lateral faces 43b and 43d correspond to the short sides of the outflow bottom face 43e.

Thus, the outflow area 43 (the lateral faces 43a to 43d, and the outflow bottom face 43e) correspond to the inflow area 42 (the lateral faces 42a to 42c and the diffusion face 42d, and the inflow bottom face 42e). In particular, the lateral face 43b corresponds to the diffusion face 42d, and the lateral face 43c corresponds to the lateral face 42a. Therefore, the outflow area 43 may be the same in size as the inflow area 42 described in the first embodiment. In addition, the inclination angle between the lateral faces 43b and 43c may be the same as that between the diffusion face 42d and the lateral face 42a described in the first embodiment.

In addition, the groove part 43f is formed in the flow passage area 41 in such a manner as to extend, in plan view, from the lateral face 43b of the outflow area 43 toward the inner lateral face 41b along the inner lateral face 41a (in the -X direction, i.e., the longitudinal direction). The width of the groove part 43f in the ±Y direction is equal to the width of the outflow area 43 in the same direction. In addition, the groove part 43f is defined by a groove bottom face 43f1, a groove lateral face 43f2, and the inner lateral faces 41a and 41b.

The groove bottom face 43f1 is connected to the lateral face 43b, extends along the inner lateral face 41a (in the longitudinal direction), and is then connected to the inner lateral face 41b. The groove bottom face 43f1 is located, in the ±Z direction, lower than the flow passage bottom face 41e and higher than the outflow bottom face 43e. In addition, the groove bottom face 43f1 is substantially parallel to the flow passage bottom face 41e and the outflow bottom face 43e. The entire groove bottom face 43f1 is flat and smooth. Note that if the depth of the groove bottom face 43f1 from the flow passage bottom face 41e is too sharrow, the refrigerant does not travel straight along the groove part 43f. On the other hand, if it is too deep, the refrigerant traveling straight in the groove part 43f becomes difficult to flow out to the flow passage area 41. Therefore, the depth of the groove bottom face 43f1 from the flow passage bottom face 41e is preferably 10% or more of the depth of the outflow bottom face 43e from the flow passage bottom face 41e.

The groove lateral face 43f2 extends to the inner lateral face 41b, running parallel to the inner lateral face 41a (in the longitudinal direction). The groove lateral face 43f2 connects the groove bottom face 43f1 to the flow passage bottom face 41e. Note that the third embodiment depicts a case where the groove lateral face 43f2 is perpendicular to the groove bottom face 43f1 and the flow passage bottom face 41e; however, the groove lateral face 43f2 may be inclined at an obtuse angle to the groove bottom face 43f1. That is, the groove lateral face 43f2 may be inclined at an obtuse angle to the transverse direction (the +Y direction). This prevents eddy currents from being possibly induced when the groove lateral face 43f2 is perpendicular to the groove bottom face 43f1. Note however that if the inclination is too large, there is a risk that the refrigerant flowing into the groove lateral face 43f2 may fail to hit the multiple fins 33. For this reason, the inclination angle is, for example, greater than 90° and less than or equal to 125°. That is, the groove lateral face 43f2 has an inclination angle of greater than 90° and less than or equal to 125° to the transverse direction.

As described above, the cooling chassis 40 of the third embodiment is configured by providing the outflow area 43 and the groove part 43f on the outlet 40i side in the cooling chassis 40 of the second embodiment. That is, the outflow area 43 and the groove part 43f are point symmetrical to the inflow area 42 and the groove part 42f, respectively, to thereby keep the cooling chassis 40 balanced. This eliminates the imbalance in the pressure for feeding the refrigerant inside the cooling chassis 40, which ensures the refrigerant having flowed into the flow passage area 41 of the cooling device 3 to circulate throughout the flow passage area 41 and then be discharged.

The foregoing is merely illustrative of the principles of the present invention. Further, numerous modifications and changes will readily occur to those skilled in the art, and therefore, it is not desired to limit the disclosed technology to the exact construction and applications illustrated and described above. Accordingly, all suitable modifications and equivalents may be resorted to, falling within the scope of the present invention determined by appended claims and their equivalents.

### Reference Signs List

1: semiconductor device
2: semiconductor module
3: cooling device
10, 10a, 10b, 10c: semiconductor unit
11: insulated circuit board
11a: insulating plate
11b1, 11b2, 11b3: wiring board
11c: metal plate
12: semiconductor chip
12a: control electrodes
12b: main electrode
13a, 13b: lead frame
13a1, 13b1: main electrode bonding part
13a2, 13b2: first vertical linking part
13a3, 13b3: horizontal linking part
13a4, 13b4: second vertical linking part
13a5, 13b5: wiring bonding part
14a, 14b: bonding member
20: chassis
21: outer frame
21a, 21b, 21c, 21d: outer wall
21e, 21f, 21g: unit housing part
21i: through hole
22a, 22b, 22c: first connection terminal
23a, 23b, 23c: second connection terminal
24a: U-phase output terminal
24b: V-phase output terminal
24c: W-phase output terminal
25a, 25b, 25c: control terminal
26: wire
30: top plate
30a to 30d: lateral face
30g: insertion hole
31: top face (cooling surface)
31a to 31c: unit area
31d: cooling area
32: lower face (fin installation face)
33: fins
40: cooling chassis
40a to 40d: outer lateral face
40e: top face
40f: sealing member
40g: fastening hole
40h: inlet
40h1: inflow channel
40i: outlet
40i: outflow channel
41: flow passage area
41a to 41d: inner lateral face
41e: flow passage bottom face
42: inflow area
43: outflow area
42a to 42c, 43a to 43d: lateral face
42d: diffusion face
42e: inflow bottom face
42f, 43f: groove part
42f1, 43f1: groove bottom face
42f2, 43f2: groove lateral face
42g: guide wall
43e: outflow bottom face
44a, 44b: distribution pipe

## Claims

1. A semiconductor device, comprising:
a semiconductor chip; and
a cooling device configured to have the semiconductor chip mounted thereon, wherein:
the cooling device includes:
a top plate including a first top face on which the semiconductor chip is placed and a first lower face opposite the first top face, and
a cooling chassis including a second top face having a rectangular shape in a plan view of the semiconductor device and surrounded on all four sides sequentially by a first outer lateral face, a second outer lateral face, a third outer lateral face, and a fourth outer lateral face, on which a flow passage area is provided, which has a concave shape and includes a flow passage bottom face recessed from the second top face, the flow passage area being closed with the top plate by disposing the first lower face of the top plate on the second top face, and
the cooling chassis is configured such that:
the first outer lateral face and the third outer lateral face are located on long sides thereof and the second outer lateral face and the fourth outer lateral face are located on short sides,
an inlet is provided, on the second outer lateral face, at a position closer to the third outer lateral face, and communicates with the flow passage area, a cooling medium being introduced and flowing through the inlet in a longitudinal direction toward the flow passage area,
an inflow area is provided, on the flow passage bottom face, at a position closer to the inlet, the inflow area being recessed in a concave shape from the flow passage bottom face and communicating with the inlet, and
the inflow area includes a diffusion face opposing the inlet.

2. The semiconductor device according to claim 1, wherein:
the diffusion face is inclined at an angle of 85° or more and 95° or less to a plane parallel to the first top face of the top plate.

3. The semiconductor device according to claim 2 wherein:
the flow passage area has a rectangular shape in the plan view and includes a first inner lateral face, a second inner lateral face, a third inner lateral face, and a fourth inner lateral face opposing the first outer lateral face, the second outer lateral face, the third outer lateral face, and the fourth outer lateral face, respectively, and surrounding on all four sides of the flow passage bottom face, and
the inflow area is provided in a vicinity of a corner formed by the second inner lateral face and the third inner lateral face.

4. The semiconductor device according to claim 3 wherein:
in the plan view, a distance from the inlet to the diffusion face is 5% or more and 30% or less of a length of a long side of the flow passage bottom face.

5. The semiconductor device according to claim 1, wherein:
the inflow area further includes a guide wall opposing the inlet and located closer to the inlet than the diffusion face.

6. The semiconductor device according to claim 5, wherein:
in the plan view, a width of the guide wall is 45% or more and 55% or less of a width of the diffusion face.

7. The semiconductor device according to claim 3 wherein:
the flow passage area further includes a first groove part extending along the third inner lateral face from the diffusion face toward the fourth inner lateral face, and
the first groove part includes a first groove bottom face that is higher in position than a bottom part of the inflow area and lower in position than the flow passage bottom face.

8. The semiconductor device according to claim 7 wherein:
in the plan view, a width of the first groove bottom face in a direction parallel to the short sides is equal to a width of the inflow area in the direction parallel to the short sides.

9. The semiconductor device according to claim 3 wherein:
an outlet is provided, on the fourth outer lateral face, at a position closer to the first outer lateral face, and communicates with the flow passage area, the cooling medium being discharged through the outlet in the longitudinal direction toward the outside of the cooling chassis.

10. The semiconductor device according to claim 9 wherein:
the flow passage area further includes:
an outflow area provided, on the flow passage bottom face, at a position closer to the outlet, the outflow area being recessed in a concave shape from the flow passage bottom face and communicating with the outlet, and
a second groove part extending along the first inner lateral face from the outflow area toward the second inner lateral face.
